# FASCICULE DE BREVET EUROPEEN

(11) **EP 0 336 831 B1**
(45) Date de publication et mention de la délivrance du brevet: **17.08.1994**
(21) Numéro de dépôt: 89400917.4
(22) Date de dépôt: 04.04.1989
(51) Int. Cl.: H01L 21/20, H01L 21/82, C30B 25/04

(54) **Procédé de réalisation d'une alternance de couches de matériau semiconducteur monocristallin et de couches de matériau isolant**
Verfahren zur Herstellung von abwechselnden Schichten aus monokristallinen Halbleitermaterial und Schichten aus isolierendem Material
Process of manufacturing alternating layers of monocrystalline semiconductor material and layers of isolating material

(30) Priorité: 05.04.1988 FR 8804438
(43) Date de publication de la demande: 11.10.1989
(73) Titulaire: THOMSON-CSF, 75008 Paris (FR)
(72) Inventeur: Pribat, Didier, F-94045 Paris la Défense (FR); Karapiperis, Léonidas, F-92045 Paris la Défense (FR)
(74) Mandataire: Grynwald, Albert

(56) Documents cités:
- EP-A- 0 194 495
- FR-A- 2 440 075
- GB-A- 1 200 534
- JOURNAL OF THE ELECTROCHEMICAL SOCIETY, vol. 129, no. 10, pages 2303-2306 ; D.D. RATHMAN et al. : "Lateral epitaxial overgrowth of silicon on Si02".
- JOURNAL OF THE ELECTROCHEMICAL SOCIETY, vol. 132, no. 10, octobre 1985, pages 2445-2453, Manchester, NH, US ; H. ASAI et al. : "Lateral growth process of GaAs over tungsten gratings by metalorganic chemical vapor deposition".

## Description

L'invention concerne un procédé de réalisation d'une alternance de couches de matériau semiconducteur monocristallin et de couches de matériau isolant, et notamment un procédé de réalisation d'au moins une couche mince d'un matériau semiconducteur sur une couche d'isolant elle même déposée sur un substrat semiconducteur monocristallin, ce substrat étant un semiconducteur de type différent ou non de celui de la couche mince de façon à obtenir une structure hétéroépitaxiale.

Plus particulièrement, l'invention a trait au domaine des couches minces d'un matériau monocristallin épitaxié à partir d'une phase vapeur, sur un substrat de nature éventuellement différente : le procédé décrit selon l'invention permet en particulier de supprimer les défauts étendus à deux dimensions (macles, fautes d'empilement, parois d'antiphase dans les alliages ordonnés, sous joints de grains, etc...) ainsi que les défauts linéaires ou lignes de dislocation.

Le procédé sera décrit en appuyant sur des exemples d'homo ou d'hétéroépitaxie de matériaux semiconducteurs, mais il est bien évident que ce procédé est plus général et que son application n'est pas limitée aux seuls matériaux semiconducteurs.

Les défauts étendus que l'on trouve dans les couches minces épitaxiées à partir d'une phase vapeur sur un substrat monocristallin de nature et de paramètre de maille différents trouvent essentiellement leur origine dans le mode initial de nucléation du dépôt.

Schématiquement, pour les dépôts en phase vapeur, on observe trois modes de nucléation et de croissance d'un film mince monocristallin sur un substrat également monocristallin.

Tout d'abord un mode de nucléation et de croissance couche par couche, où l'arrangement des atomes déposés s'effectue dans le plan atomique exposé du substrat (arrangement bi-dimensionnel), par exemple par croissance latérale à l'échelle de la monocouche à partir de marches monoatomiques qui constituent des sites préférentiels d'adsorption. Lorsque tous les sites de dépôts sont saturés sur la surface exposée du substrat, la croissance se poursuit au niveau de la deuxième monocouche selon le même mécanisme et ainsi de suite, plan par plan. Ce type de mécanisme s'observe dans les cas d'homoépitaxie bien évidemment (silicium dopé sur silicium par exemple) mais aussi dans les cas d'hétéroépitaxie de métaux (Cd ou W par exemple) ou de semiconducteur (Ga₁₋ₓ Alₓ As sur GaAs, GaInAsP sur InP...). Les défauts étendus générés au cours de l'épitaxie sont des dislocations d'interfaces qui relaxent l'énergie élastique emmagasinée dans le dépôt du fait d'un éventuel désaccord de maille avec le substrat. Ces dislocations se propagent dans l'épaisseur du dépôt et leur élimination totale est pratiquement impossible.

Le deuxième mode de croissance observé procède d'un mécanisme de nucléation en îlot ; selon ce mécanisme, des paquets d'atomes (clusters) se forment initialement à la surface du substrat en général sur des sites de défauts émergeants ; ceux de ces clusters qui atteignent la taille du germe critique croissent alors pour former des îlots de phase condensée, îlots qui coalescent lorsqu'ils se rejoignent afin de former un film qui n'est vraiment continu qu'après avoir atteint une certaine épaisseur. On observe ce type de croissance lorsque l'énergie de liaison entre atomes du dépôt est supérieure à l'énergie de liaison entre atomes du dépôt et atomes du substrat. Ceci est souvent le cas pour les films de métaux ou semiconducteurs sur des substrats isolants. Les défauts présents dans ces films consistent d'une part en lignes de dislocations (de même que précédemment) qui permettent de relaxer l'énergie mécanique du au désaccord de maille et, d'autre part, en macles qui du fait du mécanisme de croissance particulier sont générées à la jonction entre îlots afin d'accommoder de légères désorientation. Ces macles croissent avec le film et en conséquence leur élimination est très difficile. Ainsi, plus de 25 ans après la première publication de l'hétéroépitaxie de silicium sur un substrat de saphir, on se satisfait toujours d'un matériau épitaxié très maclé et la technologie de réalisation de dispositifs à partir du matériau en question a dû s'adapter à sa mauvaise qualité cristalline. Il est en particulier, impossible d'utiliser l'implantation ionique, car au cours du recuit thermique, les défauts ponctuels d'implantation précipitent sur les défauts étendus et ne guérissent pas.

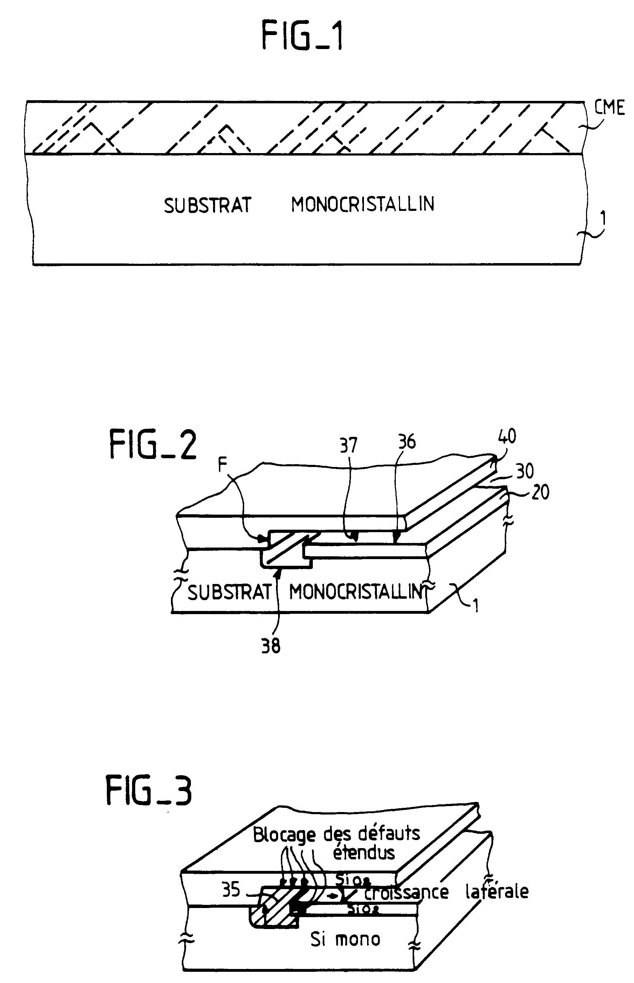

Enfin, le troisième mode de croissance observé est une combinaison des deux premiers modes précédemment décrits, à savoir que la croissance débute à deux dimensions (premier cas ci-dessus décrit) sur quelques monocouches, puis des îlots commencent à apparaître selon le deuxième mécanisme précédemment décrit. Ces îlots en coalescant vont ensuite donner naissance à un film continu. De même que dans les cas précédents, les défauts vont consister en lignes de dislocations et en macles dont l'élimination qui ne s'effectue que par annihilation (rencontre de deux dislocations de vecteurs de Burgers opposés ; rencontre de deux joints de macles faisant avec le plan du substrat deux angles supplémentaires) sera très difficile si l'on veut rester dans un domaine d'épaisseur déposée raisonnable. La situation est illustrée par la figure 1 où la couche mince épitaxiée CME, déposée sur le substrat 1, comporte des dislocations ou bien des plans de macles représentés par les lignes en pointillés.

Aux différents défauts inhérents au mode de croissance s'ajoutent les défauts engendrés par la mise sous contrainte du dépôt au refroidissement, les coefficients de dilatation entre substrat et dépôt n'étant que très rarement accordés. Ce processus de refroidissement est susceptible de générer d'autres dislocations, mais aussi des phénomènes de glissement conduisant à la formation de fautes d'empilement.

Le procédé selon l'invention permet de bloquer la propagation de la majorité des défauts précédemment décrits et en conséquence il permet d'obtenir des couches minces de qualité cristalline pratiquement parfaite. Le procédé selon l'invention permet aussi d'obtenir des empilements de couches monocristallines isolées par des diélectriques amorphes ou polycristallins.

L'invention concerne donc un procédé de réalisation par croissance en phase vapeur d'une couche mince monocristalline d'un matériau semiconducteur selon les revendications 1 et 2.

Les différents objets et caractéristiques de l'invention apparaîtront plus clairement dans la description qui va suivre, faite à titre d'exemple, en se reportant aux figures annexées qui représentent :
- la figure 1, un dispositif à semiconducteurs hétéroépitaxié et présentant des dislocations et des plans de macles ;
- les figures 2 et 3, des exemples simplifiés de réalisation du procédé selon l'invention ;
- la figure 4, un exemple de dépôt d'une couche semi-conductrice selon l'art connu ;
- les figures 5 à 16, différentes étapes de réalisation du procédé selon l'invention ;
- les figures 17 à 27, différentes étapes d'une amélioration du procédé selon l'invention ;
- les figures 28 à 34, différentes étapes d'une variante du procédé selon l'invention ;
- les figures 35 à 37, un système permettant de réaliser des couches minces monocristallines selon l'invention ;
- les figures 38 à 42, une autre amélioration du procédé selon l'invention ;
- les figures 43 à 50, une autre variante du procédé de réalisation selon l'invention ;
- les figures 51 à 53, une autre variante du procédé de réalisation selon l'invention ;
- la figure 54, une application de l'invention à un dispositif à trois dimensions.

Le procédé selon l'invention consiste à interposer sur le trajet de croissance du cristal en couche mince à obtenir, un étranglement qui va bloquer la croissance des défauts qui ont été décrits précédemment en relation avec la figure 1.

Les figures 2 et 3 illustrent de façon simplifiée le procédé de base de l'invention. Selon ce procédé on réalise une structure du type représentée par la figure 2. Cette structure comporte principalement un espace 30 délimité par les faces 36 et 37 de deux couches 20 et 40. Les deux couches 20 et 40 sont en matériau sur lequel, compte tenu des conditions de dépôt utilisées, on n'observe pas de dépôt du matériau semiconducteur à faire croître. Dans le fond de l'espace 30 est située une portion ou germe 38 d'un matériau semiconducteur (par exemple le substrat). Plus précisément, selon l'exemple de réalisation de la figure 2, les couches 20 et 40 sont réalisées sur un substrat 1. Le germe 38 est alors une partie du substrat 1 située au dessous du plan de la surface 36 de la couche 20.

Dans ces conditions, comme cela est représenté en figure 3, une épitaxie sélective d'un matériau semiconducteur réalisée dans l'espace 30 donne lieu à une croissance monocristalline du matériau semiconducteur sur le germe 38. Cette croissance progresse perpendiculairement au plan du germe 38 (verticalement) jusqu'à remplir la cavité 35 puis progresse latéralement (horizontalement) dans l'espace 30.

Si le matériau semiconducteur épitaxié est différent de celui du substrat 1, on voit donc sur la figure 3 que la croissance épitaxiale s'effectue d'abord verticalement dans la cavité 35 et ensuite latéralement entre les bandes de diélectrique 20 et 40. Ainsi les défauts générés lors de l'étape de croissance verticale (hétéroépitaxie) sont bloqués par les couches diélectriques 20 et 40 lors de l'étape de croissance latérale. D'autre part, il n'y a pas génération de nouveaux défauts lors de cette même étape de croissance latérale car le procédé est devenu homoépitaxial lors de la croissance latérale; les défauts une fois bloqués disparaissent donc définitivement de la couche mince. La cavité 35 représente en fait un piège à défauts.

De plus, dans le cas d'homoépitaxie (par exemple Si sur Si, GaAs sur GaAs, ou InP sur InP),le procédé d'épitaxie latérale selon l'invention permet de réaliser aisément des empilements de couches minces monocristallines séparées par des couches diélectriques non monocristallines.

Toutefois, comme le montrent les deux figures 2 et 3, la croissance du cristal ne peut s'effectuer de façon latérale que si l'on peut se placer dans des conditions telles que l'on n'ait pas de dépôt sur les surfaces 36 et 37 des couches de confinement 20 et 40 (conditions de dépôt sélectif). Ainsi, si le substrat est en silicium, les couches de confinement en silice et que l'on effectue un dépôt de silicium à partir de SiH₄ ou SiH₂Cl₂ on sait ajuster les différents paramètres de dépôt (température, pressions partielles de SiH₄ et HCl, etc...) de façon a ce que les conditions précitées soient remplies et on observe une croissance épitaxiale latérale sans que l'on ait dépôt de Si polycristallin sur la silice pour les conditions d'épitaxie sélective (voir par exemple l'article de BORLAND et DROWLEY, dans Solid State Technology Août 1985, P.141 et voir l'article de KARAPIPERIS et Coll. dans Proceedings of the 18th Intl. Conference on Solid State Devices and Materials, Tokyo 1986, P.713).

En ce qui concerne les composés III-V et le GaAs en particulier, on utilisera de préférence pour obtenir une sélectivité de dépôt, une méthode permettant de se placer près de l'équilibre thermodynamique en conditions de légère sursaturation. Ainsi, la méthode d'épitaxie en phase vapeur à partir de chlorures (VPE Vapor Phase Epitaxy), permet d'opérer dans de telles conditions. On utilise d'une part AsCl₃ et éventuellement HCl dilués dans H₂ en tant que sources gazeuses et d'autre part Ga comme source solide. On opère dans un four où la température de la source de Ga est par exemple de l'ordre de 800°C, tandis que l'échantillon sur lequel on travaille est maintenu à une température inférieure, de l'ordre de 650-700°C, ce qui donne la condition de sursaturation légère annoncée.

En ce qui concerne InP on travaille avec une source gazeuse PH₃ et HCl dans H₂ et une source solide In. L'échantillon est placé autour de 700°C et la source d'In est chauffée à température supérieure de même que précédemment.

En utilisant les paramètres précités, on obtient une nucléation sélective sur les parties cristallines exposées du substrat (surfaces à faibles barrières de nucléation). Par suite, on observe un dépôt sur ces mêmes parties exposées et aucun dépôt sur des surfaces étrangères à barrière de nucléation plus élevée (surfaces diélectriques par exemple, mais aussi surfaces métalliques tel que tungstène).

Des exemples de cette sélectivité de dépôt entre GaAs et SiO₂ et InP et SiO₂ peuvent être trouvés à titre indicatif dans un article récent de M.ERMAN et Collaborateurs, dans SPIE, Vol.651, Integrated Optical Circuit Engineering III (1986) P.75.

On a cité GaAs et InP à titre d'exemple, mais on peut déposer, de façon sélective, des alliages ternaires ou quaternaires (GaInAsP) en utilisant des sources gazeuses AsH₃, PH₃ et HCl dans H₂ et des sources solides Ga et In et toujours en se plaçant près de l'équilibre thermodynamique en conditions de légère sursaturation.

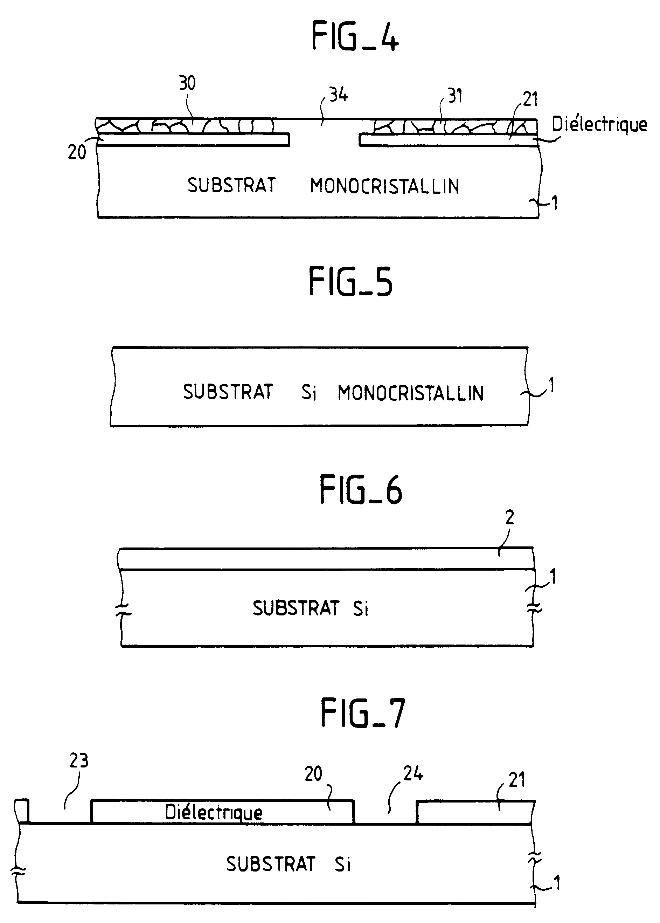

Si (toujours en ce qui concerne des composés III-V) l'on utilise une méthode de dépôt fonctionnant à pression atmosphérique et très loin de l'équilibre thermodynamique, telle que la MOCVD par exemple (de l'anglais Metal Organic Chemical Vapor Déposition) on dépose du matériau semiconducteur monocristallin 34 sur les surfaces de germination exposées du substrat 1 et du matériau polycristallin 30, 31 sur les surfaces étrangères 20, 21 (diélectriques ou métalliques) comme cela est représenté sur la figure 4 (voir par exemple R. AZOULAY et Collaborateurs, Journal of Crystal Growth 55, 1981, P.229).

Dans cette méthode MOCVD, la source de composé III est organométallique (triméthylgallium, triéthylgallium, triméthylindium, triéthylindium, etc...) tandis que la source du composé V est un hydrure (AsH₃, PH₃...). Précisons tout de même que dans certaines conditions et toujours en travaillant à pression atmosphérique, on peut obtenir une certaine sélectivité de dépôt en travaillant avec des bandes de silice ou de tungstène de largeur inférieure à 40 micromètres, ce qui est toutefois limitatif et difficilement exploitable (voir K. YAMAGUCHI et Coll. Japanese Journal of Applied Physics, Vol.24, N° 12, 1985, P.1666).

Par contre, en travaillant à pression réduite (10 mm de colonne de Hg) et toujours en utilisant la méthode MOCVD, K. KAMON et Coll. (Journal of Crystal Growth 73.198573) ont démontré, récemment, que l'on pouvait aussi obtenir une excellente sélectivité de dépôt entre une surface (001) de GaAs exposée et un film de nitrure de silicium (SiNx) déposé par CVD plasma à 250°C. Bien que la méthode utilisée (MOCVD) se situe hors de l'équilibre thermodynamique, la sélectivité est obtenue du fait d'une plus grande diffusivité superficielle, sur les surfaces diélectriques, des produits de décomposition du triméthylgallium (ou du triméthylindium) dans les conditions de pression réduite utilisées.

Finalement, il convient de noter qu'en utilisant la technique de l'épitaxie par jet moléculaire (ou MBE de l'anglais Molecular Beam Epitaxy) à partir de composés organo métalliques du gallium ou de l'indium (triméthylgallium ou triéthylindium, etc...) on obtient aussi la même sélectivité de dépôt, bien qu'étant très loin de l'équilibre thermodynamique, ceci probablement pour les mêmes raisons de diffusivité superficielle accrue sur les surfaces diélectriques lorsque la pression environnante est faible (voir par exemple E.TOKUMITSU et Coll. Journal of Applied Physics.55, 1984, page 3163).

En résumé, on sait maîtriser l'épitaxie sélective de composés III-V divers (GaAs, InP, Ga In As, Ga In As P. etc...) par plusieurs techniques distinctes, à savoir :
1 - épitaxie en phase vapeur par la méthode des chlorures (VPE Vapor Phase Epitaxy) ;
2 - épitaxie en phase vapeur et à basse pression par la méthode des organométalliques (LP.MOCVD Low Pressure Metal Organic Chemical Vapor Deposition) ;
3 - épitaxie par jet moléculaire par la méthode des organométalliques (MOMBE Metal Organic Molecular Beam Epitaxy).

De plus, la méthode MOCVD à pression atmosphérique permet de déposer des couches continues polycristallines sur les surfaces diélectriques et monocristallines sur les surfaces exposées d'un substrat aussi monocristallin.

Compte tenu de ce qui vient d'être décrit, on voit que l'on peut tout d'abord effectuer en homoépitaxie (ou en hétéroépitaxie d'un composé présentant le même paramètre de maille) des empilements de couches III-V monocristallines isolées par des couches diélectriques.

Cependant, comme indiqué précédemment, le principal intérêt de la méthode réside dans la réalisation de structures hérétoépitaxiales exemptes de défauts étendus.

En se reportant aux figures 5 à 18, on va donc maintenant décrire un exemple de réalisation détaillé du procédé de l'invention. Cet exemple concerne la réalisation de couches minces monocristallines de composés III-V sur un substrat en silicium.

Lors d'une première étape, on réalise une plaquette 1, par exemple en silicium standard d'orientation (100) ou (110) de diamètre 10 ou 12.5 cm (4 ou 5 pouces), telle que représentée en figure 5.

Lors d'une deuxième étape représentée en figure 6, on réalise une couche 2 d'un matériau diélectrique, SiO₂ par exemple obtenue par oxydation thermique de la surface supérieure du substrat 1.

Lors d'une troisième étape représentée en figure 7, on ouvre dans la couche 2, un système d'ouvertures 23, 24 sous forme de bandes parallèles par exemple, mettant à nu le substrat dans ces ouvertures entre les bandes de diélectrique 20, 21. La largeur des ouvertures 23, 24 peut être, par exemple, de 0,5 à quelques micromètres et les espacements 20, 21 de quelques micromètres à quelques centaines de micromètres. L'orientation dans le plan supérieur du substrat des bandes de substrat mises à nu sera effectuée de telle façon que, compte tenu des conditions de dépôt sélectif ultérieurement utilisées, la facette de croissance latérale ne soit pas limitante.

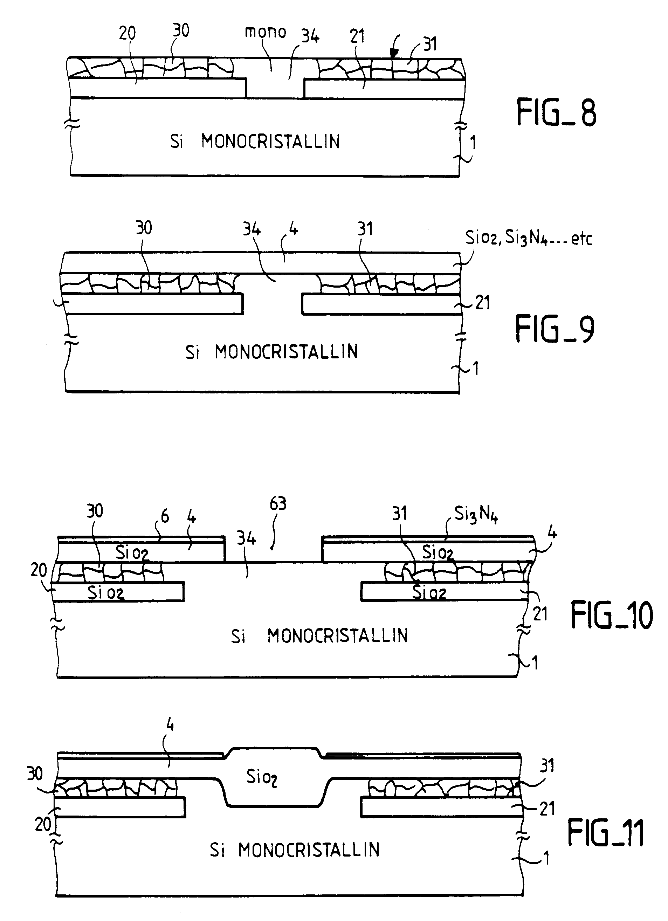

Lors d'une quatrième étape (figure 8) on fait croître par épitaxie sélective (mélange SiH₄ + H₂ à 950°C et pression atmosphérique par exemple) du silicium monocristallin dans les ouvertures 23, 24 sur le substrat mis à nu et du silicium polycristallin sur les bandes de diélectrique 20, 21. L'ensemble est planarisé soit naturellement (croissance plus rapide dans les ouvertures monocristallines 23, 24 que sur les bandes 20, 21) soit en effectuant préalablement un dépôt sélectif dans les ouvertures 23, 24.

Lors d'une cinquième étape on oxyde thermiquement une partie du dépôt de silicium réalisé précédemment. Une variante peut consister à déposer, par une méthode connue de l'homme de l'art, une couche 4 de diélectrique tel que SiO₂ ou, mieux encore compte tenu des opérations suivantes, Si₃N₄. Cependant on pourra préférer l'oxydation thermique, de façon à fournir ultérieurement des interfaces semiconducteurs III-V silice thermique que l'on pense plus abruptes. On obtient ainsi une structure telle que représentée en figure 9.

Lors d'une sixième étape, on dépose, sur la couche 4 d'oxyde thermique, une couche mince 6 de nitrure de silicium Si₃N₄ qui aura pour effet de bloquer l'oxydation ultérieure du silicium aux endroits où ce blocage sera désiré.

Lors d'une septième étape, on grave dans l'ensemble de la couche 6 de Si₃N₄ et de la couche 4 de silice thermique des ouvertures 63 au même pas que les ouvertures réalisées au cours de la troisième étape de façon à ce que ces ouvertures aboutissent sur le silicium monocristallin 34. On obtient une structure telle que représentée en figure 10.

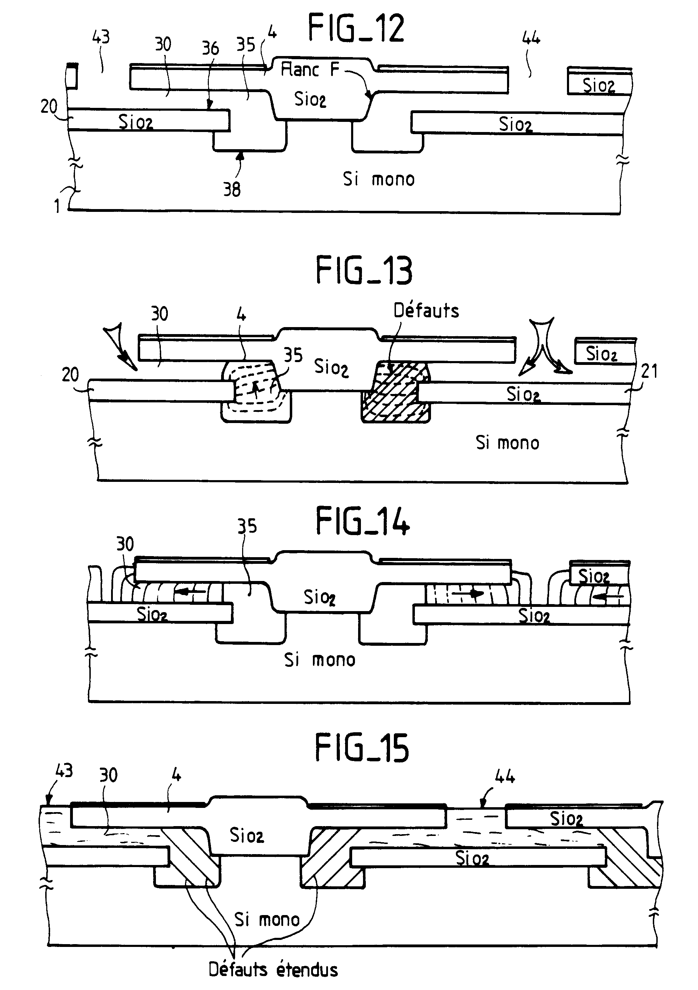

Lors d'une huitième étape, on oxyde le silicium précédemment mis à nu dans la région centrale de la bande 63. On réalise donc une oxydation localisée (procédé de type LOCOS) ainsi que représenté sur la figure 11. Cette oxydation localisée a pour effet d'augmenter le volume du matériau comme cela est représenté en figure 11. Il est à noter que, ainsi que décrit ci-dessus, la septième étape peut être précédée par un dépôt d'une couche 6 d'un matériau inoxydable (Si₃N₄ par exemple). La septième étape d'attaque chimique est donc également réalisée dans cette couche 6 qui permet ainsi, lors de l'oxydation, de protéger la couche 4. (Procédé d'oxydation localisée type LOCOS)

Lors d'une neuvième étape, on découpe, par gravure, un nouveau réseau de bandes dans la couche 4. Ces bandes sont séparées par des ouvertures 43, 44 aboutissant sur le semiconducteur polycristallin 30, 31. Ces bandes sont décalées par rapport aux précédentes, le décalage pouvant varier entre quelques micromètres et quelques centaines de micromètres. De plus, ces bandes sont centrées par rapport au système de bandes découpé lors de l'étape 3.

Lors d'une dixième étape, par les ouvertures 43, 44 ainsi gravées, on attaque le silicium polycristallin à l'aide de l'un des réactifs connus de l'homme de l'art. Une fois le silicium polycristallin enlevé, on continue l'attaque, de façon à pratiquer un évidement 35 dans le matériau monocristallin. Le fond 38 de cet évidement est situé plus bas que le plan supérieur du premier diélectrique 20, de façon à ce que l'on impose nécessairement, avant l'étape de croissance latérale, une étape préalable de croissance verticale. C'est d'ailleurs pour favoriser cette étape préalable de croissance verticale que l'on a antérieurement pratiqué la huitième étape d'oxydation localisée, qui fait que l'on ne peut avoir croissance latérale hétéroépitaxiale à partir du flanc F de la cavité cette dernière étant constituée de silice amorphe. On obtient ainsi une structure telle que représentée en figure 12.

Lors d'une onzième étape, on effectue en mode de dépôt et d'épitaxie sélectifs dans les conditions précisées précédemment (VPE, LP MOCVD, MOMBE), le remplissage des cavités 30 et 35 précédemment évidées. Comme le montre la figure 13, le remplissage s'effectue d'abord verticalement dans la cavité 35 et les défauts générés à l'interface silicium monocristallin du substrat 1 et couche mince (Composé III-V par exemple) vont se propager au cours de cette croissance verticale jusqu'à rencontrer un plan de diélectrique 20, 21 ou 4 sur lequel ils vont être bloqués. Une fois la cavité 35 remplie, la croissance ne pourra plus s'effectuer que latéralement comme représenté en figure 14, mais de façon homoépitaxiale, puisque les molécules de vapeur arrivant rencontreront un germe de même nature. Ainsi, la croissance de la couche dans l'espace 30 peut continuer et les défauts restent bloqués par les plans de diélectrique 20, 21 ou 4. On a ainsi fait croître une couche mince monocristalline sans défauts étendus entre deux bandes de silice thermique comme cela est représenté en figure 15.

Lors d'une douzième étape, on planarise le matériau semiconducteur au niveau des ouvertures 43, 44 (par attaque localisée par exemple) et on réalise l'attaque et l'ablation de la couche 4 de diélectrique de façon à obtenir une couche plane de matériau semiconducteur dans l'espace 30.

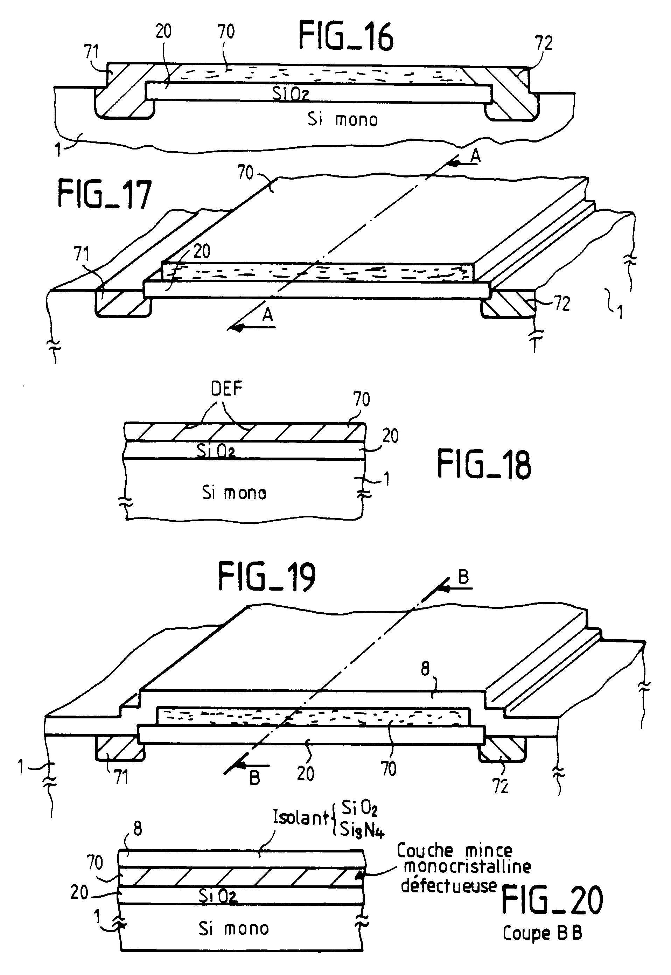

On objectera cependant que les défauts étendus générés dans des plans formant, avec le plan de la figure 15, un dièdre d'angle quelconque (différent de 90° comme cela est représenté) sont susceptibles de se propager dans la couche mince en croissance latérale. La situation est résumée sur les figures 16, 17, 18. La figure 16 reprend une partie de la figure 15. Le dépôt obtenu par croissance latérale a été planarisé à l'endroit des ouvertures dans la silice supérieure 4 (par exemple par attaque dans un plasma type CF₄ s'il s'agit d'un dépôt de semiconducteur composé III-V) et cette silice supérieure 4 a ensuite été enlevée (douzième étape). On est donc en présence d'une couche mince monocristalline 70 isolée du substrat (sauf en ses extrémités 71 et 72) par une couche mince de silice thermique 20, l'ensemble étant supporté par un substrat de silicium.

La figure 17, est une vue en perspective de la figure 16, avec comme légère différence le fait que la couche mince ait été complètement isolée du substrat par gravure des bandes latérales 71 et 72 de germination constituées de matériau très défectueux. La figure 18 représente une coupe AA de la figure 17 et montre que les défauts étendus DEF générés dans des plans formant un dièdre quelconque avec le plan de la figure 16 se sont propagés lors de la croissance latérale. Les défauts dans cette vue en coupe ont été représentés pour des raisons de simplification, dans le cas où la charnière du dièdre est constituée par l'intersection du plan de la figure 16 avec le plan d'orientation supérieur du substrat.

L'invention permet également de pallier cet inconvénient, en proposant une méthode d'élimination de ces défauts. Cette méthode est divulguée dans le procédé qui va être décrit.

Après avoir réalisé la douzième étape décrite précédemment, on réalise une treizième étape au cours de laquelle on redépose sur la couche mince monocristalline 70 une couche de diélectrique 8 (SiO₂, Si₃N₄, etc...) comme cela est représenté sur la vue en perspective de la figure 19. La figure 20 représente d'autre part une coupe de la structure obtenue. L'épaisseur de la couche isolante 8 est par exemple, de 5.10⁻² à quelques micromètres typiquement.

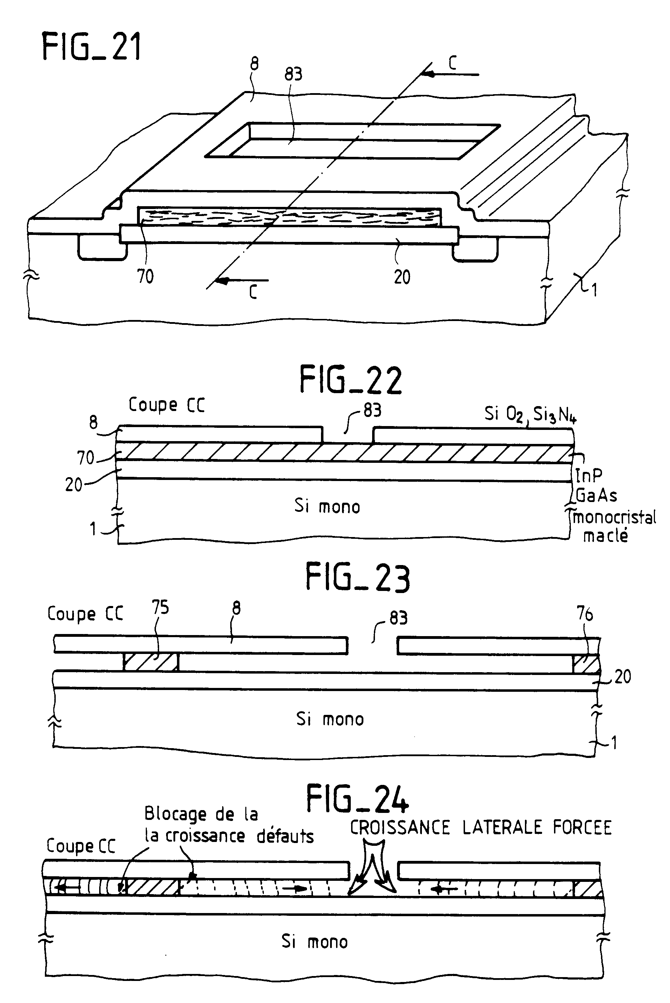

Lors d'une quatorzième étape, et comme cela est représenté en figure 21, on grave des ouvertures (83) dans le précédent dépôt diélectrique en les orientant parallèlement à la trace (dans le plan supérieur du dépôt) des plans de croissance des défauts étendus (joints de macles, parois d'antiphase, etc...). Dans le cas particulier que nous avons choisi, l'orientation de ce système d'ouvertures (83) est perpendiculaire à celle des systèmes d'ouvertures (23, 24) réalisés lors de la troisième étape. Il faut bien noter toutefois que selon la nature et la symétrie des défauts, ce deuxième système de bandes peut être orienté à 60° ou à 120° du premier (celui de l'étape 3) ou selon une orientation quelconque, le point essentiel étant que la trace du plan des défauts étendus dans un des plans de confinement soit parallèle a la grande dimension des bandes d'ouvertures (83). La largeur des bandes obtenues et leur pas de répétition ont des valeurs tout à fait similaires à celles utilisées pour réaliser les bandes de la troisième étape ou bien celles de la neuvième étape. La longueur de ces bandes est de l'ordre de grandeur de la dimension latérale des couches minces obtenues au cours de la onzième étape et peut atteindre quelques centaines de micromètres. La figure 22 représente une vue en coupe de la figure 21.

Lors d'une quinzième étape, on attaque le matériau monocristallin 70 maclé ou défectueux par les ouvertures 83 précédemment pratiquées ; on retrouve ainsi une configuration comparable à celle précédant la onzième étape. (voir figure 23).

Lors d'une seizième étape, représentée en figure 24, on refait croître en conditions d'épitaxie sélective (VPE, LP.MOCVD, MOMBE pour des composés III-V) une couche mince homoépitaxiale à partir des germes 75 et 76 restant après l'opération d'élimination de la plus grande partie du matériau en couche mince maclé 70. Cette étape est analogue à la onzième étape précédemment décrite. Cependant cette deuxième croissance se fait selon une direction faisant un angle avec la direction de croissance de la onzième étape. Plus particulièrement, le front de croissance est sensiblement parallèle à la trace des plans de défauts dans un plan d'une face d'une des couches de confinement.

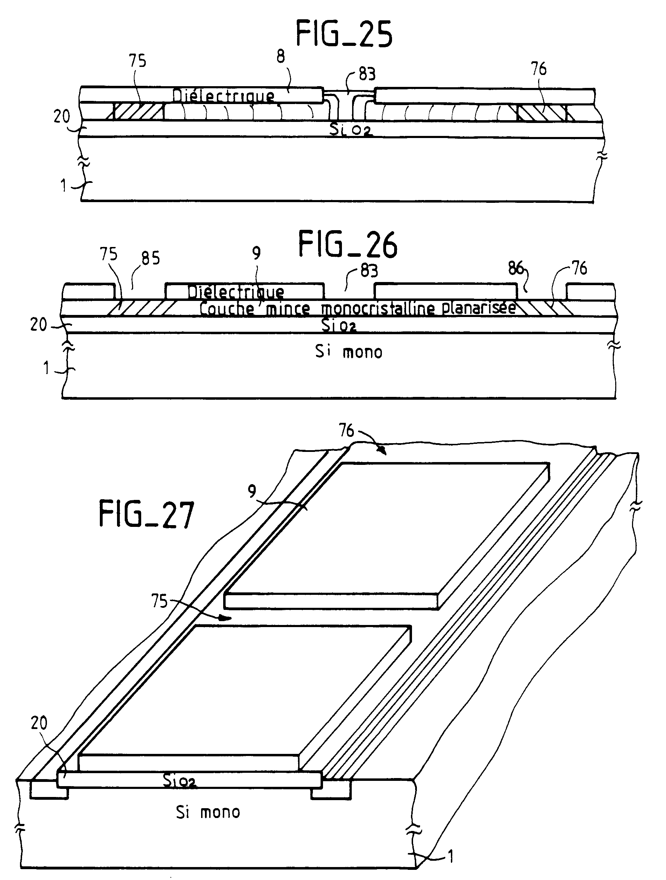

Lors d'une dix septième étape, représentée en figure 25, on remplit la partie gravée lors de la quinzième étape de façon à remplir également les ouvertures 83 dans le diélectrique supérieur. Si ces ouvertures présentent une largeur trop importante, on réalise des phases supplémentaires qui seront décrites ultérieurement.

Lors d'une dix huitième étape, après planarisation de la couche mince monocristalline (par attaque chimique, plasma ou oxydation localisée), on ouvre dans le diélectrique supérieur 8 des bandes 85, 86, de façon à mettre à nu les zones toujours maclées 75 et 76. On obtient une structure telle que représentée en figure 26.

Lors d'une dix neuvième étape, on élimine par attaque chimique les zones 75 et 76 constituées de matériaux défectueux et on enlève (éventuellement) le diélectrique supérieur 8 de façon à obtenir des pavés réguliers 9 indéxés et exempts de défauts étendus de couche mince monocristalline (de composés III-V par exemple) sur un support de silice thermique 20. La taille de ces pavés (qui peuvent présenter des dimensions de quelques 10² x quelques 10² µm²) est choisie par l'utilisateur lors de la réalisation des différentes étapes technologiques. La structure obtenue est représentée en figure 27. A noter que l'opération d'élimination des défauts étendus peut être effectuée une troisième fois etc...selon la symétrie de croissance de ces défauts.

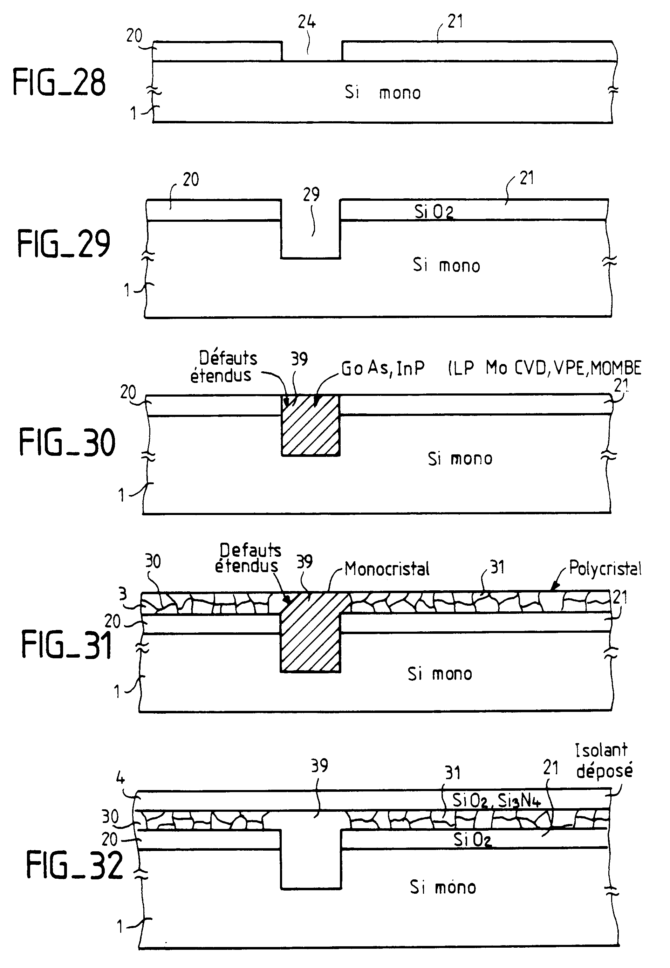

En se reportant aux figures 28 à 34, on va maintenant décrire une variante du procédé de l'invention.

Lors d'une première étape on réalise, sur un substrat 1 monocristallin, une couche 2 d'un matériau diélectrique, puis lors d'une deuxième étape on grave dans cette couche des bandes 20 et 21 séparées par des ouvertures 24. On obtient la structure représentée en figure 28.

Lors d'une troisième étape représentée en figure 29, afin de pouvoir ultérieurement introduire une étape de croissance verticale et pour éviter d'utiliser des épaisseurs de silice (ou de tout autre diélectrique) déraisonnables, on grave, (par les moyens connus de homme de l'art) des sillons 29 dans le substrat sous jacente 1 à l'emplacement des ouvertures 24. On notera toutefois que l'on pourrait se contenter d'une structure de départ telle que celle représentée à la figure 28, cette dernière suffisant en effet a introduire une étape de croissance verticale.

Lors d'une quatrième étape représentée en figure 30, on remplit, en conditions d'épitaxie sélective (VPE, LP. MOCVD, MOMBE pour les composés III-V) les sillons 29 précédemment ouverts, de façon à introduire une étape de croissance verticale au cours de laquelle sont générés à partir des différentes interfaces des défauts étendus.

Lors d'une cinquième étape représentée en figure 31, on dépose en conditions normales (MOCVD à pression atmosphérique pour les III-V par exemple) une couche mince 3 sur la structure précédente. Cette couche 3 sera monocristalline (mais toutefois défectueuse) sur la partie monocristalline 39 et elle sera polycristalline (30, 31) sur le diélectrique. D'autre part, la structure obtenue est plane.

Lors d'une sixième étape représentée en figure 32, on dépose sur la structure précédente et par les moyens connus de l'homme de l'art une couche mince 4 isolante ou non (SiO₂, Si₃N₄, etc...).

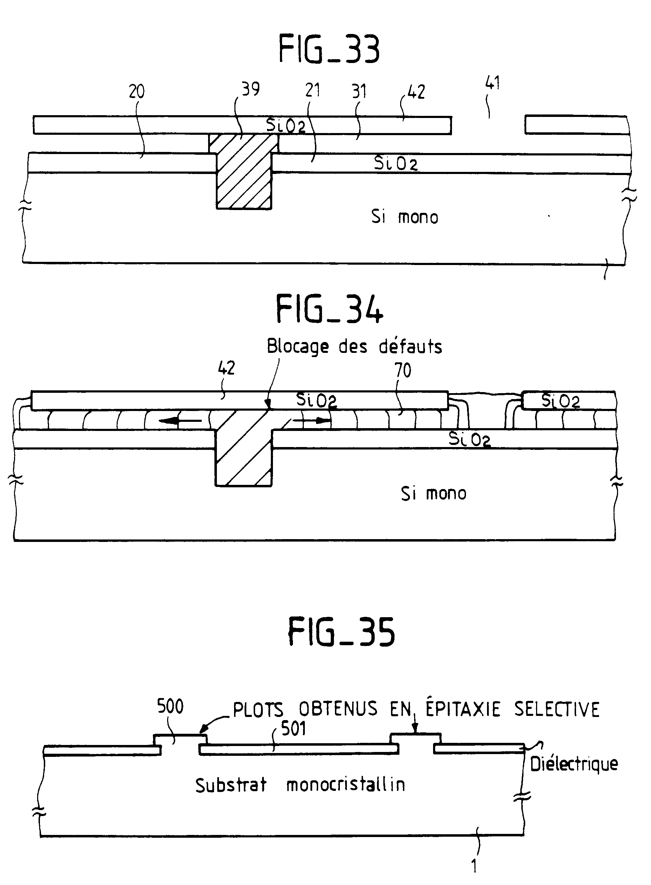

Lors d'une septième étape, représentée en figure 33, on grave, dans cet isolant, un deuxième système de bandes 42 qui seront décalées de quelques micromètres à quelques centaines de micromètres et disposées symétriquement par rapport au précédent système de bandes (24). Les ouvertures (41) pratiquées aboutissent sur les zones de matériau déposé polycristallin (31). A partir de ces ouvertures, on attaque le polycristal (31) déposé sur le premier diélectrique lors de la cinquième étape de façon à mettre à nu le germe monocristallin 39.

Lors d'une huitième étape représentée figure 34, on refait croître latéralement par épitaxie sélective à partir des germes 39 mis à nu au cours de l'étape précédente, des rubans de couche mince monocristalline (III-V éventuellement), la propagation des défauts étant, selon la figure 34 bloquée sur le plan inférieur de la couche 4.

On obtient ainsi une couche uniforme et exempte de défauts étendus de semiconducteur monocristallin 70 de nature différente de celle du substrat après avoir réalisé éventuellement une neuvième étape de planarisation de la couche de semiconducteur et d'attaque du diélectrique 42.

De plus on peut également réaliser le procédé précédent de la treizième à la dix neuvième étape correspondant aux figures 17 à 27 de façon à éliminer ceux des défauts qui n'ont pu être bloqués lors de l'étape de croissance latérale précédente. Ce procédé de la treizième à la dix neuvième étape peut être répété une troisième fois si nécessaire et même autant de fois que nécessaire pour que l'élimination des défauts étendus soit effectuée dans toutes les orientations.

On voit donc que l'invention concerne un procédé de croissance épitaxiale, caractérisé en ce que :
- (i) la croissance s'effectue à partir d'une phase vapeur,
- (ii) la croissance est canalisée par deux plans constitués de matériaux, éventuellement distincts, à barrière de nucléation plus élevée que celle du germe auquel ils laissent accès et à barrière de nucléation aussi plus élevée que celle de la couche mince en cours de croissance à partir de la phase vapeur ;
- (iii) la croissance est initiée par une phase verticale de façon à permettre le développement des défauts étendus avant l'étape de croissance latérale proprement dite qui produira le blocage de ces mêmes défauts étendus.

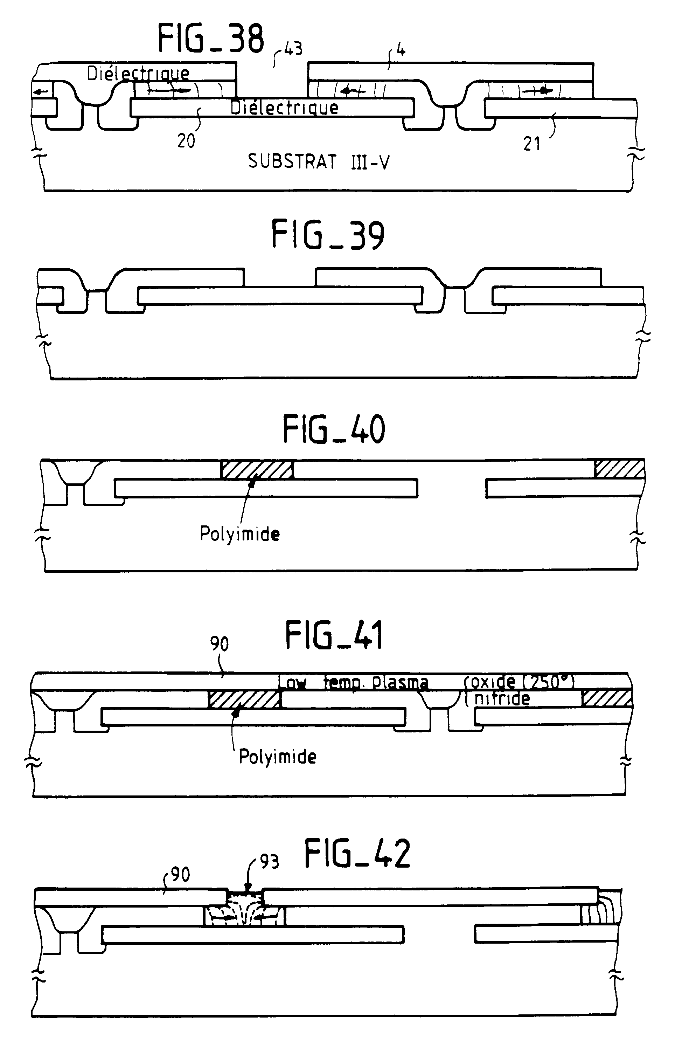

Selon un perfectionnement du procédé de l'invention, permettant d'éviter un débordement supérieur du film de croissance, on prévoit au cours de la onzième étape précédemment décrite en relation avec la figure 14, d'arrêter le dépôt de semiconducteur lorsque la croissance atteint les ouvertures 43, 44. On obtient ainsi une structure telle que représentée en figure 38.

Au cours d'une première phase auxiliaire représentée en figure 39, on enlève alors la couche supérieure 4, de silice en masquant éventuellement les couches inférieures 20, 21.

Au cours d'une deuxième phase auxiliaire représentée en figure 40 on "planarise" la structure à l'aide d'un dépôt type polyimide effectué à la tournette par exemple (machine à déposer les résines photosensibles) et en employant une étape d"etch back", si nécessaire.

Au cours d'une troisième phase auxiliaire représentée en figure 41, on dépose une couche 90 d'oxyde (SiO₂) ou de nitrure (Si₃N₄) à basse température (LTO) par pyrolyse de Si H₄ + N₂O assistée par plasma à 250°C (par exemple) sur la structure précédemment planarisée.

Au cours d'une quatrième phase auxiliaire on découpe dans cette dernière couche de silice ou de nitrure 90 des ouvertures 93 de façon à se ramener à une structure identique à celle obtenue lors de la description de la dixième ou de la quinzième étape précédente. L'ouverture dans la silice est à présent compatible avec un remplissage correct (sans débordement vertical pour obtenir la jonction des deux fronts de cristallisation) des bandes vides comprises entre les bandes de silice pyrolitique. On dissout au cours d'une cinquième phase auxiliaire le polyimide à l'aide d'un solvant approprié et on répète l'opération de croissance latérale décrite dans la onzième étape tel que cela est représenté en figure 42.

Ces différentes phases peuvent également être prévue comme phases auxiliaires de la dix septième étape.

Ces phases auxiliaires présentent un intérêt lorsque l'étendue des espaces 30 (trop grande) et l'épaisseur des espaces 30 (trop faible) nécessite des ouvertures (43, 44) de relative grandes dimensions pour permettre le passage du gaz de croissance.

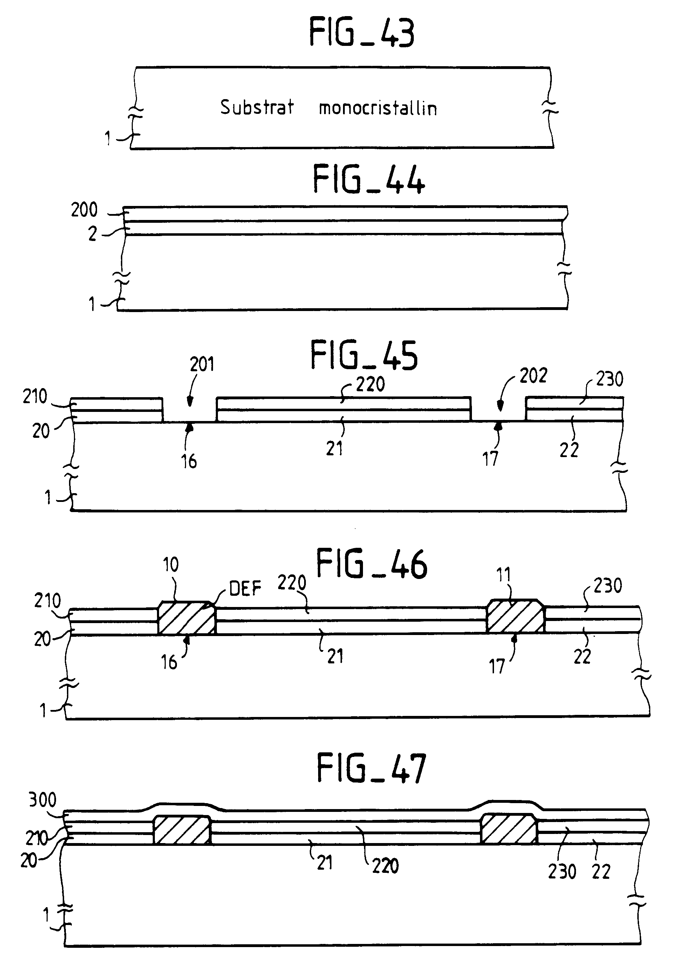

En se reportant aux figures 43 à 50, on va décrire une autre variante du procédé de l'invention.

Selon cette variante, on utilise un substrat monocristallin 1 tel que représenté à la figure 43, sur lequel on dépose successivement une couche uniforme de matériau diélectrique 2 et une couche uniforme 200 d'un matériau qui présente une excellente sélectivité d'attaque chimique par rapport au diélectrique 2 d'une part et par rapport au matériau constitutif de la couche 300 (dont la description va suivre) d'autre part. La situation est résumée sur la figure 44.

Selon la figure 45, on grave ensuite dans les deux couches précédentes un système de bandes 201, 202 qui mettent périodiquement à nu le substrat monocristallin 1 (germes 16, 17). La largeur des bandes 201 et 202 est comprise entre 0,5 et quelques micromètres typiquement, tandis que les espaces 210, 220, 230 ou 20, 21, 22 entre deux bandes sont compris entre quelques micromètres et quelques centaines de micromètres.

On remplit par CVD en conditions de dépôt et d'épitaxie sélectifs les bandes 201 et 202, de façon à obtenir un matériau semiconducteur (10, 11) de nature différente du substrat. Ce matériau est monocristallin mais défectueux comme le montre la figure 46.

Selon la figure 47, on dépose sur la structure précédente une couche 300 uniforme d'un matériau présentant une excellente sélectivité d'attaque chimique par rapport au matériau 200 et présentant de plus vis à vis de la phase gazeuse "mère" une barrière de nucléation plus élevée que le plan d'orientation supérieur du substrat et que le matériau semiconducteur 10, 11. En d'autres termes, ce matériau 300 (de même d'ailleurs que le diélectrique 2) permet, dans les conditions utilisées, l'obtention d'un dépôt sélectif sur les surfaces exposées monocristallines du substrat et du matériau semiconducteur que l'on cherche à obtenir.

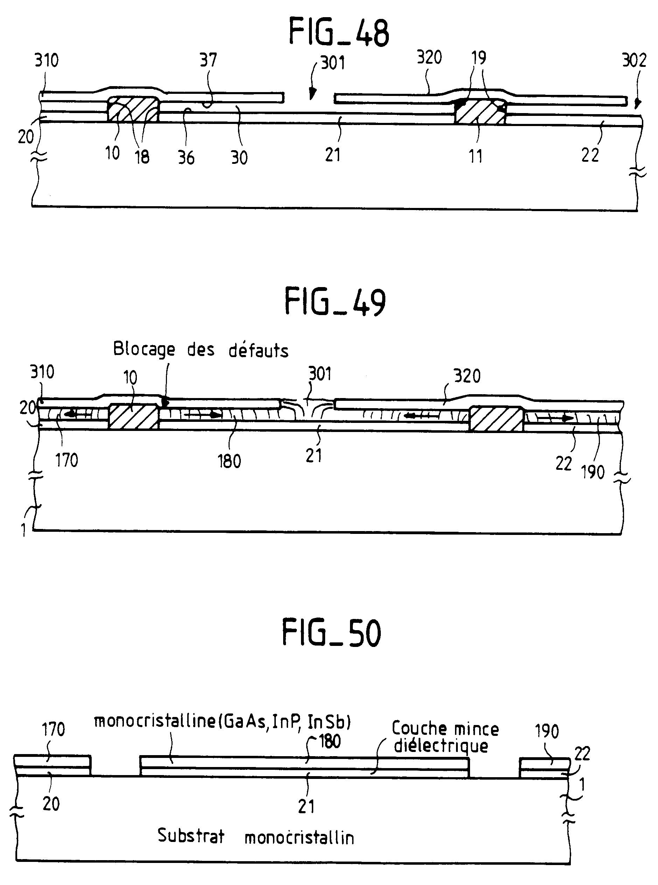

On ouvre ensuite dans ce dépôt 300 des bandes 301, 302 de largeur similaire aux bandes 201, 202 espacées de quelques micromètres à quelques centaines de micromètres et délimitant des rubans 310, 320 qui reposent en leur région centrale sur le matériau semiconducteur monocristallin 10, 11. A partir de ces ouvertures 301, 302, on attaque le matériau 200, de façon à dissoudre les rubans 210, 220 et 230. Cette situation qui est résumée sur la figure 48 a pour conséquence de mettre à nu des germes 18, 19 du matériau semiconducteur monocristallin 10, 11.

On peut ensuite comme le montre la figure 49 refaire croître par CVD en conditions de dépôt et d'épitaxie sélectifs une couche mince de matériau semiconducteur 170, 180, 190 à partir des germes 18, 19. De même que précédemment, la propagation des défauts étendus sera bloquée par la surface inférieure 37 des rubans 310, 320 et la couche mince de matériau semiconducteur sera par la suite d'excellente qualité cristalline.

Enfin, comme le montre la figure 50, après planarisation par attaque localisée dans les fenêtres 301, 302, ablation de la couche 300 et isolement par élimination des bandes 10 et 11 défectueuses, on obtient une couche mince monocristalline, et exempte de défauts étendus, d'un matériau semiconducteur (GaAs, InP, InSb...) sur un substrat monocristallin de nature différente (Si par exemple), l'isolement électrique entre la couche mince et le substrat étant réalisé par la couche 20, 21, 22 de matériau diélectrique.

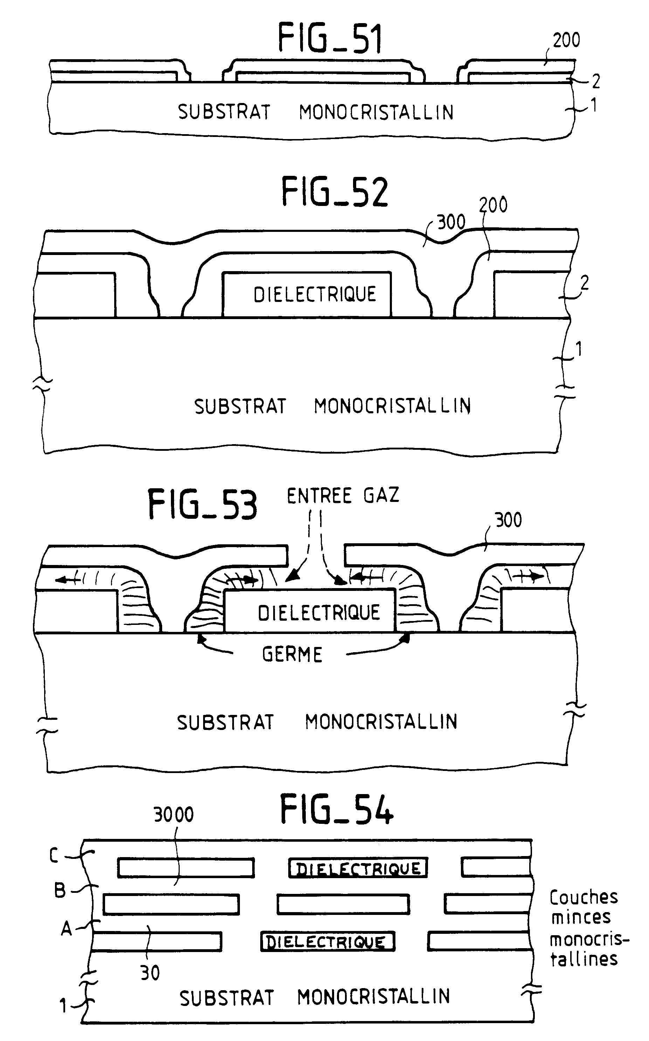

En se reportant aux figures 51 à 53, on va maintenant décrire une autre variante du procédé de l'invention. Selon cette variante, on commence par réaliser les première, deuxième et troisième étapes du procédé général, on réalise ensuite les étapes suivantes :
a)- On dépose une couche 200 uniforme d'un matériau qui présente une excellente sélectivité d'attaque chimique par rapport au diélectrique d'une part et à la couche 300 (dont la description va suivre) d'autre part. Cette couche 200 peut être du silicium amorphe, un diélectrique, un métal ou bien du polyimide ou équivalent.
b)- On grave dans la couche précédente un système de bandes, de façon à mettre le substrat à nu dans les espaces laissés libres par la gravure du premier système de bandes. La situation est représentée sur la figure 51. On s'est arrangé pour que les ouvertures effectuées dans la couches 200 soient de largeur inférieure à celle des premières ouvertures et symétriquement disposées au milieu de ces mêmes premières ouvertures.
c)- On redépose sur la structure précédente une couche 300 uniforme d'un matériau présentant une excellente sélectivité d'attaque chimique avec le matériau 200 et présentant de plus vis à vis de la phase gazeuse "mère" une barrière de nucléation plus élevée que les principaux plans cristallographiques du substrat et du semiconducteur que l'on cherche à obtenir. La situation est schématisée sur la figure 52.

A partir de cette situation, on répète la neuvième et la dixième étape du procédé général. On dissout la couche 200 selon la dixième étape du procédé général et on refait croître par CVD en conditions d'épitaxie sélective, à partir du germe constitué par la face supérieure du substrat, une couche mince du matériau semiconducteur voulu selon la onzième étape de ce même procédé général (voir figure 53).

Selon l'exemple de réalisation de la figure 54, on peut, en répétant le procédé décrit précédemment, réaliser sur une structure obtenue par les procédés précédents, une deuxième, puis une troisième structure similaire, et ainsi de suite. On peut ainsi obtenir une alternance de couches minces de semiconducteurs monocristallins et d'isolants. Ces couches minces peuvent être constituées du même matériau semiconducteur monocristallin (par exemple GaAs ou InP) sur un substrat différent (par exemple silicium), mais il est bien évident que l'on peut aussi obtenir des couches minces de natures différentes entre elles. Ainsi, et strictement à titre d'exemple non limitatif, le substrat 1 peut être en silicium, la couche A en arséniure de gallium (GaAs), la couche B en phosphure d'indium (InP) et la couche C en antimoniure d'indium (InSb). La figure 54 a été représentée avec un empilement de 3 couches minces monocristallines sur un substrat aussi monocristallin. Il est bien évident que l'on peut continuer cet empilement et que la structure finale peut légèrement différer du schéma de cette figure. Un réseau de bandes de semiconducteur sur isolant peut donc être réalisé, les zones de germination pouvant être superposées ou décalées.

En réalisant sur le substrat initial et successivement sur chaque niveau de semiconducteur des composants actifs, on obtient un circuit intégré à trois dimensions, l'élaboration du niveau j de circuits se faisant sans dégradation du niveau j-1 déjà réalisé et processé , du fait de la relativement basse température utilisée dans le procédé CVD.

Dans toutes les descriptions divulguées jusqu'à présent, le confinement de la couche mince en croissance latérale a été effectué à l'aide de dépôts divers (éventuellement oxydés) et photogravés.

Le rôle de ces différents dépôts a été de fournir la base de l'édification des surfaces de confinement. Il faut toutefois bien remarquer que toute autre opération ou série d'opération pouvant conduire à la formation d'un canal latéral permettant d'une part à une phase gazeuse "mère" d'accéder à une zone de germination et d'autre part de confiner la croissance monocristalline à partir de cette zone de germination, est susceptible d'être utilisée.

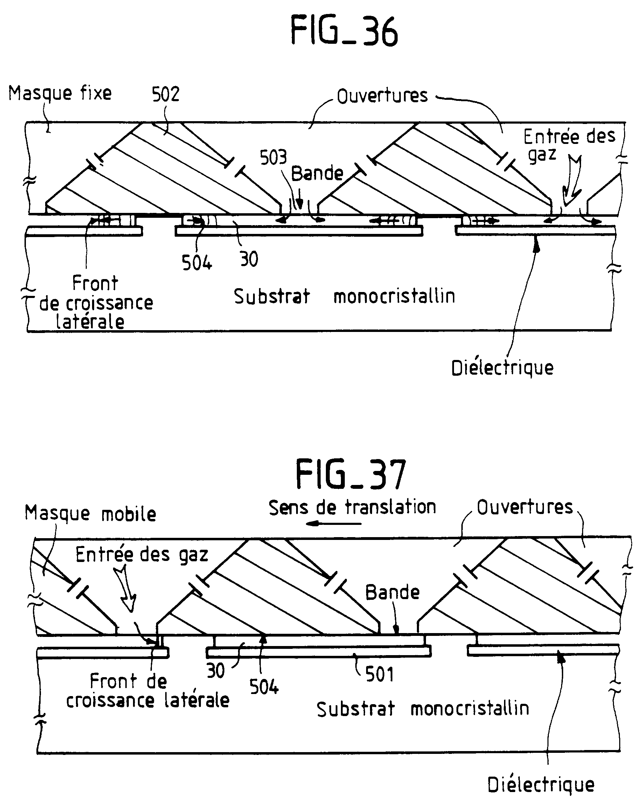

Ainsi les figures 35 à 37 proposent une méthode de réalisation des surfaces de confinement quelque peu différente. Selon cette méthode, on commence par effectuer une épitaxie 500 localisée (homoépitaxie ou hétéroépitaxie) sur un substrat 1 après dépôt préalable de diélectrique 501 et gravure de bandes dans ce diélectrique (voir figure 35). On vient ensuite positionner sur ce substrat un masque 502 dans lequel on a ouvert un système de bandes parallèles 503. Ce masque est constitué ou recouvert d'un matériau à barrière de germination plus élevée que la couche que l'on veut faire croître. On effectue ensuite l'opération de croissance latérale à partir des germes 500 obtenus par épitaxie localisée, le volume de confinement 30 étant limité dans sa partie supérieure par le plan inférieur (504) du masque 504 et dans sa partie inférieure par le diélectrique déposé sur le substrat. La situation est schématisée sur la figure 36.

On peut aussi comme le montre la figure 37 utiliser un masque 502 mobile que l'on va déplacer à la vitesse de croissance du front latéral. Ceci permet de réaliser des couches d'étendue plus importante.

Le procédé de l'invention peut être appliqué à la réalisation de couches minces monocristallines de matériaux semiconducteurs sur isolants amorphes ou polycristallins. Il peut permettre la réalisation de structures particulières (transistor à effet de champ à double grille, transistors à base perméable, hétéro-structures et super-réseaux latéraux, etc...).

Le procédé de l'invention permet ainsi de réaliser des croissance avec des semiconducteurs de nature différentes et d'obtenir des structures hétéroépitaxiales dans lesquelles les différentes couches sont néanmoins monocristallines et ne présentent pas de dislocation ni de plans de défauts.

L'invention est également applicable à titre général à toute structure à base de semiconducteurs de types différents.

## Revendications

1. Procédé de réalisation d'une couche mince en matériau semiconducteur monocristallin d'un premier type, caractérisé en ce qu'il comporte :
- la réalisation sur un substrat (1) en matériau d'un deuxième type d une cavité (30) délimitée par deux couches de confinement (20, 40) en matériau distinct de celui du premier type de telle façon que, lors d'une croissance, il ne pourra y avoir ni nucléation, ni dépôt du matériau semiconducteur du premier type sur les surfaces exposées des couches de confinement, l'une des couches de confinement étant sur le substrat, une extrémité de la cavité s'étendant sur une partie de la surface du substrat nonoccupée par ladite couche de confinement de telle manière que ladite cavité comporte une extrémité communiquant à angle droit avec la surface du substrat (1) et une ouverture (44) située à une autre extrémité ;
- une croissance en phase vapeur du matériau semiconducteur du premier type entre les deux couches de confinement (20, 40) par l'ouverture (44) à partir du substrat (1), cette croissance se faisant d'abord perpendiculairement à la face du substrat (1) puis selon le plan des couches de confinement (20, 40).

2. Procédé de réalisation d'une couche mince en matériau semiconducteur monocristallin d'un premier type, caractérisé en ce qu'il comporte :
- la réalisation sur la surface d'un substrat en matériau d'un deuxième type, d'un germe (39) en matériau du premier type par une croissance perpendiculaire à la surface du substrat ;
- la réalisation d'une cavité (30) délimitée par deux couches de confinement (20, 40) en matériau distinct de celui du premier type de telle façon que, lors d'une croissance, il ne pourra y avoir ni nucléation ni dépôt du matériau du premier type sur les surfaces exposées des couches de confinement, ladite cavité comportant : une extrémité communiquant avec le germe et une autre extrémité constituant une ouverture (44) située à une autre extrémité ;
- une croissance en phase vapeur du matériau du premier type dans la cavité (30), par l'ouverture, à partir du germe.

3. Procédé de réalisation selon la revendication 1, caractérisé en ce que la cavité (30) est défini par deux faces (36, 37), comprises dans deux plans parallèles ou non, des deux couches de confinement (20, 21 et 4, 40, 41, 42 ou 310) ; un germe (38, 39, 16, 17) n'étant pas situé entre les deux plans et communiquant avec la cavité (30), la croissance du matériau monocristallin se faisant dans un premier temps perpendiculairement au plan d'au moins une des deux couches de confinement jusqu'à atteindre au moins le plan ou le niveau du plan de confinement (37) le plus proche, puis la croissance se poursuivant dans le volume délimité par ces plans, selon une première direction prédéterminée, entre les deux couches de confinement.

4. Procédé de réalisation selon la revendication 3, caractérisé en ce que le germe (38, 16) communique avec la cavité (30) soit par au moins un conduit (35) réalisé en un matériau du même type que ceux des deux couches de confinement, soit par une ouverture latérale éventuellement obstruée par du matériau semiconducteur monocristallin défectueux (10).

5. Procédé de réalisation selon l'une des revendications 1 ou 2, caractérisé en ce qu'après obtention de ladite couche mince de matériau monocristallin une ouverture (83) est réalisée dans l'une desdites couches de confinement (8) cette ouverture étant orientée sensiblement parallèlement à la trace des plans de défauts résiduels dans l'un ou l'autre des plans correspondant à la surface des couches de confinement, le matériau monocristallin étant en partie retiré entre les deux couches de confinement, au moins un germe de ce matériau étant seulement conservé, une autre croissance monocristalline étant réalisée entre les deux couches de confinement selon une direction de croissance sensiblement perpendiculaire à la trace des plans résiduels de défauts dans l'un ou l'autre des plans correspondant à la surface des couches de confinement.

6. Procédé de réalisation d'une couche de matériau semiconducteur monocristallin sur une première couche d'un matériau isolant (2) réalisée sur un substrat (1) semiconducteur monocristallin selon la revendication 1, caractérisé en ce qu'il comporte les étapes suivantes :
- a) une première étape de réalisation sur le substrat (1) semiconducteur monocristallin de ladite première couche de matériau isolant (2) ;
- b) une deuxième étape de gravure de premières ouvertures (23, 24) dans la première couche de matériau isolant ;
- c) une troisième étape de réalisation par CVD, dans les premières ouvertures (23, 24), et sur les parties de la couche d'isolant (20, 21, 22) restant après l'étape de gravure précédente, d'une couche d'un matériau semiconducteur (30, à 34), cette couche étant monocristalline ou non (34) dans les ouvertures (23, 24) et polycristalline (30, 31) sur l'isolant (20, 21) ;
- d) une quatrième étape de réalisation d'une deuxième couche (4) d'un matériau isolant sur la couche de matériau semiconducteur (30 à 34) ;
- e) une cinquième étape de gravure dans la deuxième couche (4) de matériau isolant d'au moins une deuxième ouverture (63) aboutissant sur une partie monocristalline ou non (34) de la couche de matériau semiconducteur (30 à 34) ;
- f) une sixième étape d'oxydation de la partie monocristalline ou non (34) non recouverte par la deuxième couche (4) de matériau isolant ;
- g) une septième étape de gravure dans la deuxième couche (4) de matériau isolant d'au moins une troisième ouverture (43, 44) aboutissant sur une partie polycristalline (30, 31) de la couche de matériau semiconducteur (30 à 34) ;
- h) une huitième étape d'attaque chimique à partir de l'ouverture (43, 44) du matériau semiconducteur polycristallin (30, 31) de façon à supprimer tout le matériau semiconducteur polycristallin, cette attaque étant continuée pour graver et éliminer tout ou partie du matériau semiconducteur 34 de façon à atteindre et à graver le substrat monocristallin au dessous du niveau de la face supérieure (36) de la première couche d'isolant (20) ;
- i) une neuvième étape de croissance par épitaxie sélective en phase vapeur d'un matériau semiconducteur monocristallin dans la ou les cavités (30, 31) gravées au cours de la huitième étape, cette croissance étant réalisée selon une première direction de croissance.

7. Procédé selon la revendication 6, caractérisé en ce que la cinquième étape est précédée par une phase de dépôt d'une couche (6) d'un matériau inoxydable, la cinquième étape de gravure s'effectuant également dans cette couche (6).

8. Procédé selon la revendication 6, caractérisé en ce qu'il comporte une dixième étape de retrait de la couche de matériau isolant (4).

9. Procédé selon la revendication 6, caractérisé en ce qu'il comporte :
- une onzième étape de réalisation sur l'ensemble de la structure d'une couche (8) de matériau isolant suivie d'une gravure d'une ouverture (83) orientée parallèlement au moins à une trace, dans un des plans d'une des couches de confinement, d'au moins un plan de défaut existant dans la couche (70) de matériau semiconducteur monocristallin et mettant à nu le matériau semiconducteur monocristallin défectueux (70) obtenu à la neuvième étape ;
- une douzième étape d'attaque et d'élimination par cette ouverture (83) de la majeure partie de la majeure partie du matériau semiconducteur monocristallin (70) ;
- une treizième étape de croissance d'un matériau semiconducteur monocristallin dans l'espace rendu libre au cours de la douzième étape.

10. Procédé selon la revendication 9, caractérisé en ce que la treizième étape est suivie d'une quatorzième étape d'enlèvement de la couche (8) de matériau isolant réalisée lors de la onzième étape, ensuite les onzièmes, douzième et treizième étapes sont répétées en prévoyant lors de la onzième étape une ouverture orientée parallèlement à une autre trace dans un plan de confinement d'un autre type de plan de défaut existant dans la couche de matériau semiconducteur monocristallin.

11. Procédé selon la revendication 9, caractérisé en ce que la treizième étape est suivie d'une quatorzième étape de retrait de la couche de matériau isolant (8) recouvrant la structure puis d une quinzième étape de gravure permettant d'enlever, dans la couche de matériau semiconducteur obtenue, les zones de matériau semiconducteur comportant des dislocations et autres défauts étendus.

12. Procédé selon la revendication 1, caractérisé en ce qu'il comporte les étapes suivantes :
- une première étape de réalisation, sur un substrat (1), d'au moins une bande de matériau diélectrique (2) ;
- une deuxième étape de revêtement de ces bandes (2), par un matériau (200) présentant une sélectivité d'attaque chimique par rapport aux autres matériaux ;
- une troisième étape de revêtement de l'ensemble ainsi obtenu par un matériau encapsulant (300) ;
- une quatrième étape de réalisation d'ouvertures dans le matériau encapsulant (300) au dessus de la bande de matériau diélectrique (2) ;
- une cinquième étape d'élimination, par les ouvertures (301), du matériau (200) présentant une sélectivité d'attaque chimique ;
- une sixième étape de croissance sélective par les ouvertures (301), d'un matériau semiconducteur monocristallin.

13. Procédé selon la revendication 1, caractérisé en ce qu'il comporte les étapes suivantes :
- une première étape de réalisation, sur un substrat (1), d'au moins une bande de matériau diélectrique (2) ;
- une deuxième étape de revêtement de ces bandes (2) par un matériau intercalaire semiconducteur (200) présentant une sélectivité d'attaque chimique par rapport aux autres matériaux ;
- une troisième étape de revêtement de l'ensemble ainsi obtenu par un matériau encapsulant (300) présentant une sélectivité d'attaque chimique par rapport aux couches adjacentes et ne permettant ni nucléation, ni dépôt à partir des espèces de ladite phase vapeur sur sa surface exposée à la phase vapeur ;
- une quatrième étape de réalisation d'ouvertures dans le matériau encapsulant (300) au dessus de la bande de matériau diélectrique 2 ;
- une cinquième étape d'élimination, par les ouvertures (301), du matériau intercalaire semiconducteur (200) ;
- une sixième étape de croissance et d'épitaxie sélectives par les ouvertures (301) d'un matériau semiconducteur monocristallin.

14. Procédé selon la revendication 2, caractérisé en ce que la réalisation du germe (39) de matériau semiconducteur monocristallin est réalisé par dépôt sur un substrat (1) d'une première de couche de confinement (20, 21), puis gravure dans cette couche de confinement (20, 21) d'au moins une ouverture (29) suivie d'une croissance sélective d'un matériau semiconducteur (39) à partir de la partie gravée (16, 17) du substrat, le matériau semiconducteur étant monocristallin (39) dans l'ouverture (29) et polycristallin (31) sur la première couche de confinement, ensuite l'ensemble étant recouvert par une deuxième couche de confinement (4) dans laquelle au moins une ouverture (41) est pratiquée et le semiconducteur polycristallin (31) est enlevé.

15. Procédé selon la revendication 14, caractérisé en ce que la gravure d'au moins une ouverture (29) dans la première couche de confinement se fait également en profondeur dans le substrat (1).

16. Procédé selon la revendication 1, caractérisé en ce que la réalisation d'un germe de matériau semiconducteur monocristallin est réalisé par :
- dépôt sur un substrat (1) d'une première couche de confinement (20, 21, 22) puis d'une couche intercalaire (210, 220, 230) présentant une sélectivité d'attaque chimique par rapport au matériau de la première couche de confinement (20, 21, 22) et d'une deuxième couche de confinement (300) qui sera déposée ultérieurement ;
- gravure dans la première couche de confinement et la couche intercalaire d'au moins une ouverture (201) ;
- croissance d'un germe de matériau semiconducteur monocristallin (10) dans ladite ouverture (201) jusqu'au niveau supérieur de la couche intercalaire ;
- dépôt d'une deuxième couche de confinement (300) ;
- réalisation d'au moins une ouverture dans la deuxième couche de confinement (300) et retrait du matériau de la couche intercalaire.

17. Procédé selon la revendication 1, caractérisé en ce qu'on réalise sur un substrat une première couche de confinement (501) comportant au moins une ouverture avec dans cette ouverture un plot de matériau semiconducteur monocristallin (500) réalisé à partir du substrat (1) et émergeant, au dessus de la première couche de confinement (501), d'une hauteur correspondant à l'épaisseur de la couche monocristalline à obtenir, un masque (502) possédant au moins une ouverture (503) étant placé avec une de ses faces (504) en contact avec le plot (500) et un matériau semiconducteur étant épitaxié par l'ouverture (503) de façon à ce qu'il y ait croissance d'une couche monocristalline à partir du plot (500) entre la première couche de confinement (501) et la face (504) du masque.

18. Procédé selon la revendication 17, caractérisé en ce que le masque (502) est mobile par rapport au plot (500) parallèlement à la surface de la première couche de confinement (501).

## Claims

1. Method for producing a thin layer made of monocrystalline semiconductor material of a first type, characterized in that it comprises:
- the production, on a substrate (1) made of material of a second type, of a cavity (30) delimited by two confinement layers (20, 40) made of material other than that of the first type in such a way that, during growth, it will be possible for there to be neither nucleation nor deposition of the semiconductor material of the first type onto the exposed surfaces of the confinement layers, one of the confinement layers being on the substrate, one end of the cavity extending over part of the surface of the substrate not occupied by the said confinement layer in such a manner that the said cavity comprises an end communicating at right angles with the surface of the substrate (1) and an opening (44) located at another end;
- vapour-phase growth of the semiconductor material of the first type between the two confinement layers (20, 40) through the opening (44) from the substrate (1), this growth taking place firstly perpendicular to the face of the substrate (1), then in the plane of the confinement layers (20, 40).

2. Method for producing a thin layer made of monocrystalline semiconductor material of a first type, characterized in that it comprises:
- the production, on the surface of a substrate made of a material of a second type, of a seed (39) made of material of the first type by growth perpendicular to the surface of the substrate;
- the production of a cavity (30) delimited by two confinement layers (20, 40) made of material other than that of the first type in such a way that, during growth, it will be possible for there to be neither nucleation nor deposition of the material of the first type onto the exposed surfaces of the confinement layers, the said cavity comprising: an end communicating with the seed and another end constituting an opening (44) located at another end;
- vapour-phase growth of the material of the first type in the cavity (30), through the opening, from the seed.

3. Production method according to Claim 1, characterized in that the cavity (30) is defined by two faces (36, 37), lying in two planes which may or may not be parallel, of the two confinement layers (20, 21 and 4, 40, 41, 42 or 310); a seed (38, 39, 16, 17) not being situated between the two planes and communicating with the cavity (30), the growth of the monocrystalline material taking place in the first instance perpendicular to the plane of at least one of the two confinement layers until reaching at least the plane or the level of the closer confinement plane (37), then the growth continuing in the volume delimited by these planes, along a first predetermined direction, between the two confinement layers.

4. Production method according to Claim 3, characterized in that the seed (38, 16) communicates with the cavity (30) either through at least one channel (35) produced from a material of the same type as those of the two confinement layers, or through a lateral opening which is possibly obstructed by defective monocrystalline semiconductor material (10).

5. Production method according to one of Claims 1 and 2, characterized in that, after obtaining the said thin layer of monocrystalline material, an opening (83) is produced in one of the said confinement layers (8), this opening being oriented substantially parallel to the trace of the residual defect planes in one or other of the planes corresponding to the surface of the confinement layers, the monocrystalline material being partly taken back between the two confinement layers, at least one seed of this material being only preserved, another monocrystalline growth taking place between the two confinement layers along a growth direction substantially perpendicular to the trace of the residual defect planes in one or other of the planes corresponding to the surface of the confinement layers.

6. Method for producing a layer of monocrystalline semiconductor material on a first layer of an insulating material (2) produced on a monocrystalline semiconductor substrate (1) according to Claim 1, characterized in that it comprises the following steps:
- a) a first step of producing the said first layer (2) of insulating material on the monocrystalline semiconductor substrate (1);
- b) a second step of etching first openings (23, 24) in the first layer of insulating material;
- c) a third step of producing, by CVD, in the first openings (23, 24), and on those parts of the insulating layer (20, 21, 22) remaining after the preceding etching step, a layer (30 to 34) of a semiconductor material, this layer being monocrystalline or nonmonocrystalline (34) in the openings (23, 24) and polycrystalline (30, 31) on the insulation (20, 21);
- d) a fourth step of producing a second layer (4) of an insulating material on the layer (30 to 34) of semiconductor material;
- e) a fifth step of etching, in the second layer (4) of insulating material, at least one second opening (63) ending up on a monocrystalline or nonmonocrystalline part (34) of the layer (30 to 34) of semiconductor material;
- f) a sixth step of oxidizing the monocrystalline or nonmonocrystalline part (34) which is not covered by the second layer (4) of insulating material;
- g) a seventh step of etching, in the second layer (4) of insulating material, at least one third opening (43, 44) ending up on a polycrystalline part (30, 31) of the layer (30 to 34) of semiconductor material;
- h) an eighth step of chemically etching the polycrystalline semiconductor material (30, 31) from the opening (43, 44) so as to eliminate all the polycrystalline semiconductor material, this etching being continued in order to etch and eliminate all or part of the semiconductor material 34 so as to reach and to etch the monocrystalline substrate below the level of the upper face (36) of the first insulation layer (20);
- i) a ninth step of selective epitaxial vapour-phase growth of a monocrystalline semiconductor material in the cavity or cavities (30, 31) etched during the eighth step, this growth taking place along a first growth direction.

7. Method according to Claim 6, characterized in that the fifth step is preceded by a phase of depositing a layer (6) of a nonoxidizable material, the fifth, etching, step also being carried out in this layer (6).

8. Method according to Claim 6, characterized in that it comprises a tenth step of removal of the layer (4) of insulating material.

9. Method according to Claim 6, characterized in that it comprises:
- an eleventh step of producing, on the entire structure, a layer (8) of insulating material followed by etching an opening (83) oriented parallel to at least one trace, in one of the planes of the confinement layers, of at least one defect plane existing in the layer (70) of monocrystalline semiconductor material and baring the defective monocrystalline semiconductor material (70) obtained at the ninth step;
- a twelfth step of etching and eliminating, through this opening (83), the major part of the monocrystalline semiconductor material (70);
- a thirteenth step of growth of a monocrystalline semiconductor material in the space liberated during the twelfth step.

10. Method according to Claim 9, characterized in that the thirteenth step is followed by a fourteenth step of removal of the layer (8) of insulating material produced during the eleventh step, and thereafter the eleventh, twelfth and thirteenth steps are repeated by providing, during the eleventh step, an opening oriented parallel to another trace in a confinement plane of another type of defect plane existing in the layer of monocrystalline semiconductor material.

11. Method according to Claim 9, characterized in that the thirteenth step is followed by a fourteenth step of removal of the layer (8) of insulating material covering the structure, then a fifteenth step of etching, enabling the zones of semiconductor material comprising dislocations and other extended defects to be removed from the layer of semiconductor material obtained.

12. Method according to Claim 1, characterized in that it comprises the following steps:
- a first step of producing at least one strip (2) of dielectric material on a substrate (1);
- a second step of coating these strips (2) with a material (200) exhibiting chemical-etching selectivity with respect to the other materials;
- a third step of coating the assembly thus obtained with an encapsulating material (300);
- a fourth step of producing openings in the encapsulating material (300) above the strip (2) of dielectric material;
- a fifth step of eliminating the material (200) exhibiting chemical-etching selectivity through the openings (301);
- a sixth step of selective growth of a monocrystalline semiconductor material through the openings (301).

13. Method according to Claim 1, characterized in that it comprises the following steps:
- a first step of producing at least one strip (2) of dielectric material on a substrate (1);
- a second step of coating these strips (2) with an intermediate semiconductor material (200) exhibiting chemical-etching selectivity with respect to the other materials;
- a third step of coating the assembly thus obtained with an encapsulating material (300) exhibiting chemical-etching selectivity with respect to the adjacent layers and permitting neither nucleation nor deposition from the species of the said vapour phase onto its surface exposed to the vapour phase;
- a fourth step of producing openings in the encapsulating material (300) above the strip 2 of dielectric material;
- a fifth step of eliminating the intermediate semiconductor material (200) through the openings (301);
- a sixth step of selective growth and selective epitaxy of a monocrystalline semiconductor material through the openings (301).

14. Method according to Claim 2, characterized in that the production of the seed (39) of monocrystalline semiconductor material takes place by deposition of a first confinement layer (20, 21) onto a substrate (1), then etching of at least one opening (29) in this confinement layer (20, 21) followed by selective growth of a semiconductor material (39) from the etched part (16, 17) of the substrate, the semiconductor material being monocrystalline (39) in the opening (29) and polycrystalline (31) on the first confinement layer, the whole assembly thereafter being covered with a second confinement layer (4) in which at least one opening (41) is made and the polycrystalline semiconductor (31) is removed.

15. Method according to Claim 14, characterized in that the etching of at least one opening (29) in the first confinement layer also takes place depthwise in the substrate (1).

16. Method according to Claim 1, characterized in that the production of a seed of monocrystalline semiconductor material is carried out by:
- deposition, onto a substrate (1), of a first confinement layer (20, 21, 22) then of an intermediate layer (210, 220, 230) exhibiting chemical-etching selectivity with respect to the material of the first confinement layer (20, 21, 22) and of a second confinement layer (300) which will be deposited subsequently;
- etching at least one opening (201) in the first confinement layer and the intermediate layer;
- growth of a seed (10) of monocrystalline semiconductor material in the said opening (201) as far as the upper level of the intermediate layer;
- deposition of a second confinement layer (300);
- production of at least one opening in the second confinement layer (300) and removal of the material of the intermediate layer.

17. Method according to Claim 1, characterized in that a first confinement layer (501) is produced on a substrate, this confinement layer comprising at least one opening with, in this opening, a pad (500) of monocrystalline semiconductor material produced from the substrate (1) and emerging, above the first confinement layer (501), having a height corresponding to the thickness of the monocrystalline layer to be obtained, a mask (502) possessing at least one opening (503) being placed with one of its faces (504) in contact with the pad (500) and a semiconductor material being grown epitaxially through the opening (503) so that there is growth of a monocrystalline layer from the pad (500) between the first confinement layer (501) and the face (504) of the mask.

18. Method according to Claim 17, characterized in that the mask (502) can move with respect to the pad (500) parallel to the surface of the first confinement layer (501).

## Patentansprüche

1. Verfahren zur Herstellung einer dünnen Schicht aus einem monokristallinen Material eines ersten Typs, dadurch gekennzeichnet, daß es die folgenden Schritte aufweist:
- Herstellung eines Hohlraums (30) auf einem Substrat aus einem Material eines zweiten Typs, der durch zwei Begrenzungsschichten (20, 40) aus einem von dem Material des ersten Typs verschiedenen Material abgegrenzt ist, so daß bei einem Wachstum weder eine Nukleation noch eine Abscheidung des Halbleitermaterials des ersten Typs an den freigelegten Flächen der Begrenzungsschichten auftreten kann, wobei eine der Begrenzungsschichten auf dem Substrat liegt, und sich ein Ende des Hohlraums über einen von der Begrenzungsschicht nicht belegten Teil des Substrats so erstreckt, daß der Hohlraum ein Ende aufweist, das rechtwinklig mit der Oberfläche des Substrats (1) in Verbindung steht, sowie eine Öffnung (44), die an einem anderen Ende liegt;
- ein Dampfphasenwachstum des Halbleitermaterials des ersten Typs zwischen den beiden Begrenzungsschichten (20, 40) durch die Öffnung (44) ausgehend dem Substrat (1), wobei dieses Wachstum zunächst senkrecht zur Seite des Substrats (1) und dann längs der Ebene der Begrenzungsschichten (20, 40) stattfindet.

2. Verfahren zur Herstellung einer dünnen Schicht aus einem monokristallinen Halbleitermaterial eines ersten Typs, dadurch gekennzeichnet, daß es die folgenden Schritte aufweist:
- Herstellung eines Keims (39) aus einem Material des ersten Typs auf der Oberfläche eines Substrats aus einem Material eines zweiten Typs durch ein Wachstum senkrecht zu der Oberfläche des Substrats;
- Herstellung eines Hohlraums (30), der durch zwei Begrenzungsschichten (20, 40) aus einem von demjenigen des ersten Typs verschiedenen Material abgegrenzt ist, so daß bei einem Wachstum weder eine Nukleation noch eine Abscheidung des Materials des ersten Typs an den exponierten Flächen der Begrenzungsschichten auftreten kann, wobei der Hohlraum aufweist: ein Ende, das mit dem Keim in Verbindung steht, und ein weiteres Ende, das eine an einem anderen Ende gelegene Öffnung (44) bildet;
- ein Dampfphasenwachstum des Materials des ersten Typs in dem Hohlraum (30) durch die Öffnung ausgehend von dem Keim.

3. Herstellungsverfahren nach Anspruch 1, dadurch gekennzeichnet, daß der Hohlraum (30) durch zwei Flächen (36, 37) der beiden Begrenzungsschichten (20, 21 und 4, 40, 41, 42 oder 310) bestimmt ist, die in zwei Ebenen enthalten sind, die parallel sind oder nicht, wobei ein Keim (38, 39, 16, 17) nicht zwischen den beiden Ebenen liegt und mit dem Hohlraum (30) in Verbindung steht, wobei das Wachstum des monokristallinen Materials zunächst senkrecht zur Ebene wenigstens einer der beiden Begrenzungsschichten durchgeführt wird, bis wenigstens die Ebene oder das Niveau der nächsten Begrenzungsebene (37) erreicht ist, und sich das Wachstum dann in dem von diesen Ebenen abgegrenzten Raum längs einer ersten vorbestimmten Richtung zwischen den beiden Begrenzungsschichten fortsetzt.

4. Herstellungsverfahren nach Anspruch 3, dadurch gekennzeichnet, daß der Keim (38, 16) mit dem Hohlraum (30) entweder über wenigstens eine Leitung (35) in Verbindung steht, die aus einem Material des gleichen Typs wie derjenige der beiden Begrenzungsschichten in Verbindung steht, oder über eine seitliche Öffnung, die möglicherweise durch fehlerhaftes monokristallines Material (10) verstopft ist.

5. Herstellungsverfahren nach einem der Ansprüche 1 oder 2, dadurch gekennzeichnet, daß nach dem Erhalt der dünnen Schicht aus monokristallinem Material eine Öffnung (83) in einer der Begrenzungsschichten (8) realisiert wird, wobei diese Öffnung im wesentlichen parallel zu der Spur der Ebenen von Restfehlern in der einen oder der anderen der Ebenen orientiert ist, die der Oberfläche der Begrenzungsschichten entsprechen, wobei das monokristalline Material teilweise zwischen den beiden Begrenzungsschichten zurückgezogen ist, wobei nur ein Keim dieses Materials behalten wird, wobei ein weiteres kristallines Wachstum zwischen den beiden Begrenzungsschichten längs einer Wachstumsrichtung realisiert wird, die im wesentlichen senkrecht zu der Spur der Restebenen von Fehlern in der einen oder anderen der Ebenen liegt, die der Oberfläche der Begrenzungsschichten entsprechen.

6. Verfahren zur Herstellung einer Schicht aus monokristallinem Halbleitermaterial auf einer ersten Schicht aus einem isolierenden Material (2), die auf einem monokristallinen Halbleitersubstrat (1) nach Anspruch 1 realisiert ist, dadurch gekennzeichnet, daß es die folgenden Schritte aufweist:
- a) einen ersten Schritt der Herstellung der ersten Schicht aus isolierendem Material (2) auf dem monokristallinen Halbleitersubstrat (1);
- b) einen zweiten Schritt des Ätzens erster Öffnungen (23, 24) in der ersten Schicht aus isolierendem Material;
- c) einen dritten Schritt der Herstellung einer Schicht aus einem Halbleitermaterial (30 bis 34) durch chemische Aufdampfung in den ersten Öffnungen (23, 24) und auf den Teilen der Isolierschicht (20, 21, 22), die nach dem vorhergehenden Ätzschritt bleiben, wobei diese Schicht in den Öffnungen (23, 24) monokristallin ist oder nicht monokristallin (34) und polykristallin (30, 31) auf dem Isolierstoff (20, 21);
- d) einen vierten Schritt der Herstellung einer zweiten Schicht (4) aus einem isolierenden Material auf der Schicht aus Halbleitermaterial (30 bis 34) ;
- e) einen fünften Schritt des Ätzens wenigstens einer zweiten Öffnung (63) in der zweiten Schicht (4) aus isolierendem Material, die an einem monokristallinen oder nicht monokristallinen Teil (34) der Schicht aus Halbleitermaterial (30 bis 34) endet;
- f) einen sechsten Schritt der Oxidation des monokristallinen oder nicht monokristallinen Teils (34), der von der zweiten Schicht (4) aus isolierendem Material nicht überdeckt ist;
- g) einen siebten Schritt des Ätzens wenigstens einer dritten Öffnung (43, 44) in der zweiten Schicht aus isolierendem Material (4), die an einem polykristallinen Teil (30, 31) der Schicht aus Halbleitermaterial (30 bis 34) mündet;
- h) einen achten Schritt eines chemischen Angriffs ausgehend von der Öffnung (43, 44) des polykristallinen Halbleitermaterials (30, 31), um das gesamte polykristalline Halbleitermaterial abzubauen, wobei dieser Angriff weitergeführt wird, um das gesamte oder einen Teil des Halbleitermaterials 34 zu ätzen und zu beseitigen, um das monokristalline Substrat unter dem Niveau der oberen Seite (36) der ersten Isolierstoffschicht (20) zu erreichen und zu ätzen;
- i) einen neunten Schritt des Wachstums eines monokristallinen Halbleitermaterials durch selektive Epitaxie in der Dampfphase in dem oder den Hohlräumen (30, 31), die im Verlauf des achten Schritts geätzt wurden, wobei dieses Wachstum entlang einer ersten Wachstumsrichtung realisiert ist.

7. Verfahren nach Anspruch 6, dadurch gekennzeichnet, daß dem fünften Schritt eine Phase der Abscheidung einer Schicht (6) aus einem nichtoxidierbaren Material vorausgeht, wobei der fünfte Schritt eines Ätzens ebenfalls in dieser Schicht (6) durchgeführt wird.

8. Verfahren nach Anspruch 6, dadurch gekennzeichnet, daß es einen zehnten Schritt der Verminderung der Schicht (4) aus isolierendem Material aufweist.

9. Verfahren nach Anspruch 6, dadurch gekennzeichnet, daß es aufweist:
- einen elften Schritt der Herstellung einer Schicht (8) aus isolierendem Material auf der gesamten Struktur, dem das Ätzen einer Öffnung (83) folgt, die wenigstens zu einer Spur wenigstens einer in der Schicht (70) des monokristallinen Halbleitermaterials vorhandenen Fehlerebene in einer der Ebenen einer der Begrenzungsschichten parallel orientiert ist und das im neunten Schritt erhaltene, fehlerhafte monokristalline Halbleitermaterial (70) freilegt;
- einen zwölften Schritt zum Angriff auf den größten Teil des monokristallinen Halbleitermaterials (70) und zu dessen Entfernung durch diese Öffnung (83);
- einen dreizehnten Schritt des Wachstums eines monokristallinen Halbleitermaterials in dem im Verlauf des zwölften Schritts freigemachten Raum.

10. Verfahren nach Anspruch 9, dadurch gekennzeichnet, daß auf den dreizehnten Schritt ein vierzehnter Schritt des Entfernens der Schicht (8) aus isolierendem Material folgt, die beim elften Schritt realisiert wurde, daß dann der elfte, der zwölfte und der dreizehnte Schritt wiederholt werden, wobei beim elften Schritt eine Öffnung vorgesehen wird, die parallel zu einer weiteren Spur in einer Begrenzungsebene eines anderen Typs einer Fehlerebene orientiert ist, die in der Schicht aus monokristallinem Halbleitermaterial vorhanden ist.

11. Verfahren nach Anspruch 9, dadurch gekennzeichnet, daß auf den dreizehnten Schritt ein vierzehnter Schritt der Verminderung der die Struktur überdeckenden Schicht aus isolierendem Material (8) sowie ein fünfzehnter Ätzschritt folgt, der es ermöglicht, in der erhaltenen Schicht aus Halbleitermaterial die Zonen aus Halbleitermaterial zu entfernen, die Dislokationen und andere erweiterte Fehler aufweisen.

12. Verfahren nach Anspruch 1, dadurch gekennzeichnet, daß es die folgenden Schritte aufweist:
- einen ersten Schritt der Herstellung wenigstens eines Bandes (2) aus dielektrischem Material auf einem Substrat (1);
- einen zweiten Schritt des Überziehens dieser Bänder (2) mit einem Material (200), das eine chemische Angriffsselektivität gegenüber den anderen Materialien aufweist;
- einen dritten Schritt des Überziehens der so erhaltenen Einheit mit einem einkapselnden Material (300);
- einen vierten Schritt der Herstellung von Öffnungen in dem einkapselnden Material (300) über dem Band (2) aus dielektrischem Material;
- einen fünften Schritt des Entfernens des Materials (200), das eine chemische Angriffsselektivität aufweist, durch die Öffnungen (301);
- einen sechsten Schritt des selektiven Wachstums eines monokristallinen Materials durch die Öffnungen (301).

13. Verfahren nach Anspruch 1, dadurch gekennzeichnet, daß es die folgenden Schritte aufweist:
- einen ersten Schritt der Herstellung wenigstens eines Bandes (2) aus dielektrischem Material auf einem Substrat (1);
- einen zweiten Schritt des Überziehens dieser Bänder (2) mit einem Halbleiterzwischenmaterial (200), das eine chemische Angriffsselektivität gegenüber den anderen Materialien aufweist;
- einen dritten Schritt des Überziehens der so erhaltenen Einheit mit einem einkapselnden Material (300), das eine chemische Angriffsselektivität gegenüber den angrenzenden Schichten aufweist und weder eine Nukleation noch eine Abscheidung ausgehend von den Spezies der Dampfphase an seiner der Dampfphase ausgesetzten Oberfläche aufweist;
- einen vierten Schritt der Herstellung von Öffnungen in dem einkapselnden Material (300) über dem Band (2) aus dielektrischem Material;
- einen fünften Schritt des Entfernens des Halbleiterzwischenmaterials (200) durch die Öffnungen (301);
- einen sechsten Schritt selektiven Wachstums und selektiver Epitaxie eines monokristallinen Halbleitermaterials durch die Öffnungen (301).

14. Verfahren nach Anspruch 2, dadurch gekennzeichnet, daß die Herstellung des Keims (39) aus monokristallinem Halbleitermaterial durch das Aufbringen einer ersten Begrenzungsschicht (20, 21) auf einem Substrat (1), dann durch das Ätzen wenigstens einer Öffnung (29) in dieser Begrenzungsschicht (20, 21) gefolgt von selektivem Wachstum eines Halbleitermaterials (39) ausgehend von dem geätzten Teil (16, 17) des Substrats realisiert wird, wobei das Halbleitermaterial in der Öffnung (29) monokristallin (39) und an der ersten Begrenzungsschicht polykristallin (31) ist, wobei die Einheit danach mit einer zweiten Begrenzungsschicht (4) überdeckt wird, in der wenigstens eine Öffnung (41) vorgesehen ist, und der polykristalline Halbleiter (31) entfernt wird.

15. Verfahren nach Anspruch 14, dadurch gekennzeichnet, daß das Ätzen wenigstens einer Öffnung (29) in der ersten Begrenzungsschicht ebenfalls in der Tiefe in dem Substrat (1) durchgeführt wird.

16. Verfahren nach Anspruch 1, dadurch gekennzeichnet, daß die Herstellung eines Keims aus monokristallinem Halbleitermaterial realisiert wird durch:
- Aufbringen einer ersten Begrenzungsschicht (20, 21, 22), dann einer Zwischenschicht (210, 220, 230) auf einem Substrat (1), die eine chemische Angriffsselektivität bezüglich des Materials der ersten Begrenzungsschicht (20, 21, 22) aufweist, sowie einer zweiten Begrenzungsschicht (300), die später aufgebracht wird;
- Ätzen wenigstens einer Öffnung (201) in der ersten Begrenzungsschicht und der Zwischenschicht;
- Wachstum eines Keims aus monokristallinem Halbleitermaterial (10) in der Öffnung (201) bis zum oberen Niveau der Zwischenschicht;
- Aufbringen einer zweiten Begrenzungsschicht (300);
- Herstellung wenigstens einer Öffnung in der zweiten Begrenzungsschicht (300) und Verminderung des Materials der Zwischenschicht.

17. Verfahren nach Anspruch 1, dadurch gekennzeichnet, daß auf einem Substrat eine erste Begrenzungsschicht (501) realisiert wird, die wenigstens eine Öffnung mit einem Stopfen aus einem monokristallinen Halbleitermaterial (500) darin aufweist, der ausgehend von dem Substrat (1) realisiert ist und über der ersten Begrenzungsschicht (501) mit einer Höhe austritt, die der Dicke der zu erhaltenden monokristallinen Schicht entspricht, wobei eine Maske (502), die wenigstens eine Öffnung (503) besitzt, mit einer ihrer Seiten (504) mit dem Stopfen (500) in Kontakt steht und ein Halbleitermaterial durch die Öffnung (503) epitaxial so aufgebracht wird, daß ein Wachstum einer monokristallinen Schicht ausgehend von dem Stopfen (500) zwischen der ersten Begrenzungschicht (501) und der Seite (504) der Maske erfolgt.

18. Verfahren nach Anspruch 17, dadurch gekennzeichnet, daß die Maske (502) bezüglich des Stopfens (500) parallel zu der Oberfläche der ersten Begrenzungsfläche (501) beweglich ist.
